# EUROPEAN PATENT SPECIFICATION

(11) **EP 4 489 317 B1**
(45) Date of publication and mention of the grant of the patent: **08.07.2026**
(21) Application number: 23784834.6
(22) Date of filing: 17.01.2023
(51) Int. Cl.: H04B 1/40, H04B 1/04, H04B 1/18, H03H 7/38

(54) **ELECTRONIC DEVICE COMPRISING ANTENNA**
ELEKTRONISCHE VORRICHTUNG MIT ANTENNE
DISPOSITIF ÉLECTRONIQUE COMPRENANT UNE ANTENNE

(30) Priority: 06.04.2022 KR 20220043003; 15.07.2022 KR 20220087301
(43) Date of publication of application: 08.01.2025
(73) Proprietor: Samsung Electronics Co., Ltd, Suwon-si, Gyeonggi-do 16677 (KR)
(72) Inventor: PARK, Jeongwan, Suwon-si, Gyeonggi-do 16677 (KR); SAKONG, Min, Suwon-si, Gyeonggi-do 16677 (KR); SON, Moonsoo, Suwon-si, Gyeonggi-do 16677 (KR); SHIN, Dongryul, Suwon-si, Gyeonggi-do 16677 (KR)
(74) Representative: HGF
(86) International application number: PCT/KR2023/000795
(87) International publication number: WO 2023/195606

(56) References cited:
- KR-A- 20200 037 695
- KR-B1- 101 905 791
- KR-B1- 101 905 791
- KR-B1- 101 927 940
- US-A1- 2012 319 918
- US-A1- 2013 113 677
- US-B2- 8 923 779

## Description

### [Technical Field]

The disclosure relates to an electronic device including an antenna.

### [Background Art]

The electronic device may perform wireless communication with an external electronic device using at least one antenna. The electronic device may perform antenna impedance matching to increase the transmission efficiency of the antenna. For example, impedance matching may refer to an operation of matching an antenna impedance, which changes according to various propagation environments or usage environments of the electronic device, to a characteristic impedance using a matching circuit to ensure maximum power transfer to the antenna.

Document KR 101 905 791 B1 discloses a circuit for matching impedence for an antenna.

### [Disclosure of Invention]

### [Technical Problem]

However, in order to enable the matching circuit to operate as a series variable capacitor and a shunt variable capacitor, a number of additional switches may need to be provided. This may result in higher manufacturing costs as well as lower internal space utilization of the electronic device.

Embodiments of the disclosure may provide an electronic device that may include a matching circuit configured by a plurality of capacitors, a plurality of inductors, and a first switching circuit and a second switching circuit each including a plurality of switching elements. The first switching circuit and the second switching circuit may be electrically connected via an electrical path, and the electronic device may, based on that the wireless signal is input, control the plurality of switching elements included in each of the first switching circuit and the second switching circuit to be turned on or off.

### [Solution to Problem]

The scope of the present invention is determined according to the independent claim. Various example embodiments are outlined in the dependent claims.

An electronic device according to various example embodiments of the disclosure may include: a wireless communication circuit, an antenna, a matching circuit disposed between the wireless communication circuit and the antenna, and at least one processor, comprising processing circuitry, operatively connected to the wireless communication circuit, the antenna, and the matching circuit, wherein the matching circuit includes a first switching circuit including a first switch connected to a first-first node and configured to switch a connection with ground, a second switch connected between the first-first node and a third node, a third switch connected to a first-second node and configured to switch a connection with ground, a fourth switch connected between a first-second node and the third node, a fifth switch connected to a first-third node and configured to switch a connection with ground, a sixth switch connected between the first-third node and the third node, a seventh switch connected to a first-fourth node and configured to switch a connection with the ground, and an eighth switch connected between the first-fourth node and the third node, a second switching circuit including a ninth switch connected to a second-first node and configured to switch a connection with ground, a tenth switch connected between the second-first node and the third node, an eleventh switch connected to a second-second node and configured to switch a connection with ground, a twelfth switch connected between the second-second node and the third node, a thirteenth switch connected to a second-third node and configured to switch a connection with the ground, a fourteenth switch connected between the second-third node and the third node, a fifteenth switch connected to a second-fourth node and configured to switch a connection with ground, and a sixteenth switch disposed between the second-fourth node and the third node, a first inductor connected between a first-second node and a ground, a second inductor connected between a first-fourth node and the ground, a third inductor connected between a second-fourth node and the ground, a first electrical path electrically connecting the first switching circuit and the second switching circuit, a plurality of capacitors disposed between the wireless communication circuit, the first switching circuit, and the second switching circuit, a second electrical path connecting the first electrical path with one of the plurality of capacitors, a third electrical path connecting a second-second node and a feeding point of the antenna, and a bypass line connected to the second-first node, and wherein at least one processor, individually and/or collectively, is configured to: based on a wireless signal being input, apply the wireless signal to at least one of the plurality of capacitors, control to turn on or off the plurality of switches of the first switching circuit and the plurality of switches of the second switching circuit, based on the wireless signal being applied to the at least one capacitor, and enable the matching circuit to operate as a series variable capacitor and a shunt variable capacitor, based on that the plurality of switches of the first switching circuit and the plurality of switches of the second switching circuit being controlled to be turned on or off..

### [Advantageous Effects of Invention]

An electronic device according to various example embodiments of the disclosure may, based on a wireless signal being input, control a plurality of switching elements included in each of a first switching circuit and a second switching circuit to be turned on or off, thereby enabling the switching elements to operate as a series variable capacitor and/or a shunt variable capacitor. Accordingly, various capacitor values can be obtained when performing impedance matching of the wireless signal, and thus the frequency-variable range of the wireless signal can be enlarged.

### [Brief Description of Drawings]

FIG. 1 is a block diagram of an electronic device in a networked environment according to various embodiments;
FIG. 2A is a front perspective view of an electronic device according to various embodiments;
FIG. 2B is a rear perspective view of the electronic device of FIG. 2A according to various embodiments;
FIG. 3 is an exploded perspective view of an electronic device according to various embodiments;
FIG. 4 is a block diagram of an electronic device according to various embodiments;
FIGS. 5A, 5B, and 5C illustrate examples of arrangement of a matching circuit according to various embodiments;
FIG. 6 is a configuration diagram of a matching circuit according to various embodiments;
FIG. 7 specifically illustrates a matching circuit according to various embodiments;
FIG. 8 illustrates an operation of a matching circuit according to various embodiments;
FIG. 9 illustrates an operation of a matching circuit according to various embodiments;
FIG. 10 is a diagram schematically illustrating a configuration of a series capacitor and/or a shunt capacitor according to various embodiments;
FIG. 11, 12, and 13 are configuration diagram of a matching circuit according to various embodiments;
FIG. 14 specifically illustrates a matching circuit according to various embodiments; and
FIG. 15 illustrates an operation of a matching circuit according to various embodiments.

### [Mode for the Invention]

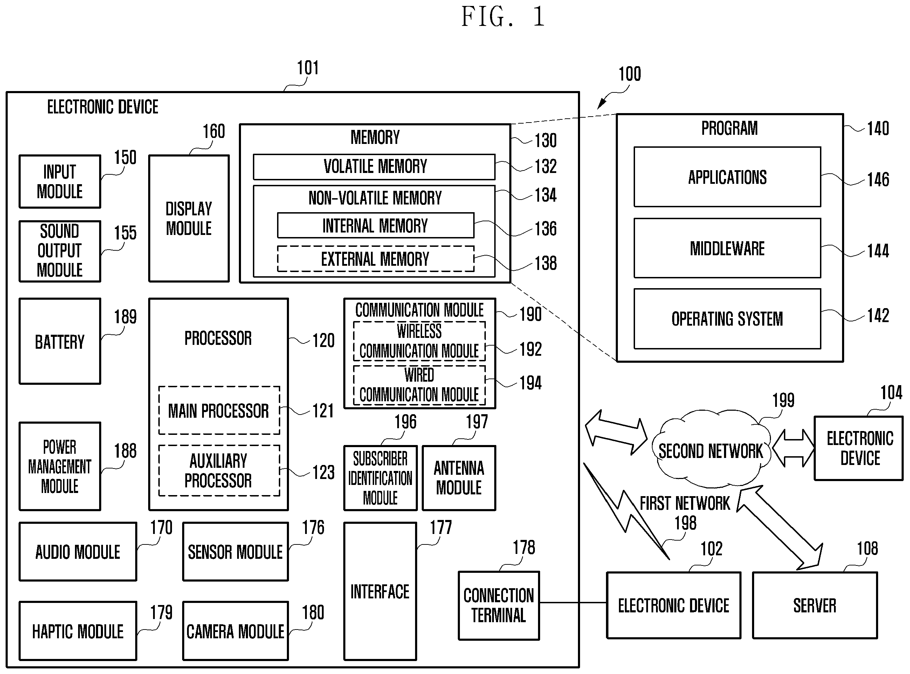

FIG. 1 is a block diagram illustrating an electronic device 101 in a network environment 100 according to various embodiments.

Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connection terminal 178, a haptic module 179, a camera module 180, a power management module 188, a battery 189, a communication module 190, a subscriber identification module (SIM) 196, or an antenna module 197. In some embodiments, at least one of the components (e.g., the connection terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134. The non-volatile memory 134 may include an internal memory 136 and/or an external memory 138.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) (e.g., speaker or headphone) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., through wires) or wirelessly. According to an embodiment, the interface 177 may include, for example, a high-definition multimedia interface (HDMI), a universal serial bus (USB) interface, a secure digital (SD) card interface, or an audio interface.

The connection terminal 178 may include a connector via which the electronic device 101 may be physically connected with the external electronic device (e.g., the electronic device 102). According to an embodiment, the connection terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., an application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, Wi-Fi direct, or infrared data association (IrDA)) or the second network 199 (e.g., a long-range communication network, such as a legacy cellular network, a fifth generation (5G) network, a next-generation communication network, the Internet, or a computer network (e.g., LAN or wide area network (WAN))). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large-scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., an mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. **In** another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively," as "coupled with," "coupled to," "connected with," or "connected to" another element (e.g., a second element), it means that the element may be coupled with the other element directly (e.g., through wires), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry." A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

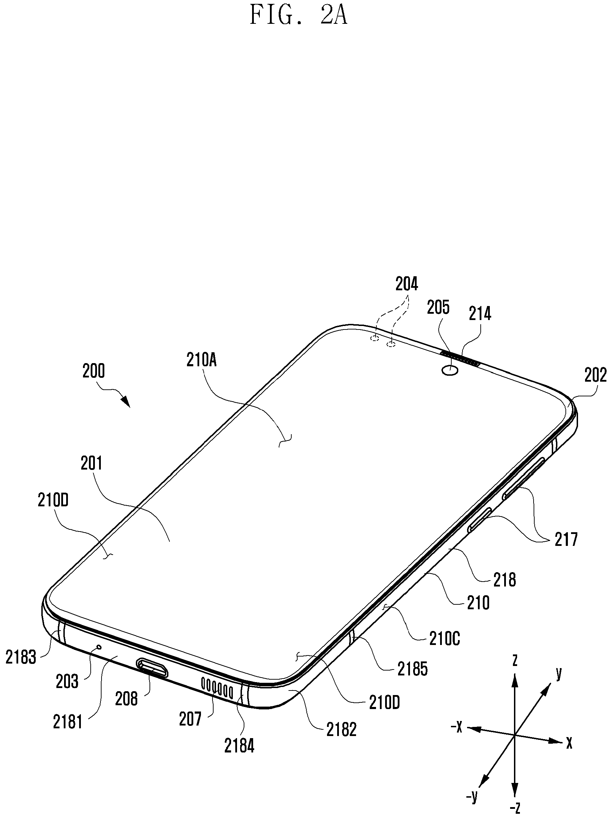

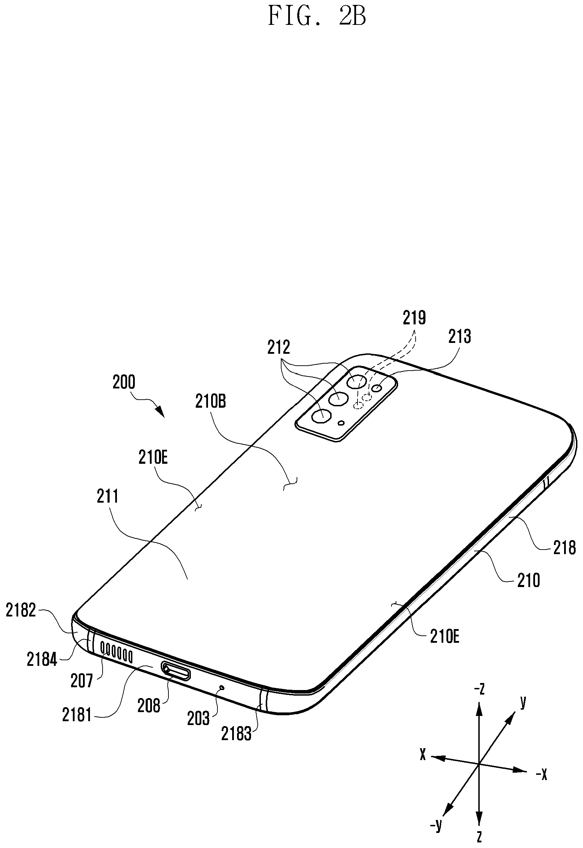

FIG. 2A illustrates a perspective view showing a front surface of an electronic device 200 according to an embodiment of the disclosure. FIG. 2B illustrates a perspective view showing a rear surface of the electronic device 200 shown in FIG. 2A according to an embodiment of the disclosure.

The electronic device 200 shown in FIGS. 2A and 2B may be similar, at least in part, to the electronic device 101 in FIG. 1, or may further include another embodiment of the electronic device.

Referring to FIGS. 2A and 2B, an electronic device 200 may include a housing 210 that includes a first surface (or front surface) 210A, a second surface (or rear surface) 210B, and a lateral surface 210C that surrounds a space between the first surface 210A and the second surface 210B. The housing 210 may refer to a structure that forms a part of the first surface 210A, the second surface 210B, and the lateral surface 210C. The first surface 210A may be formed of a front plate 202 (e.g., a glass plate or polymer plate coated with a variety of coating layers) at least a part of which is substantially transparent. The second surface 210B may be formed of a rear plate 211 which is substantially opaque. The rear plate 111 may be formed of, for example, coated or colored glass, ceramic, polymer, metal (e.g., aluminum, stainless steel (STS), or magnesium), or any combination thereof. The lateral surface 210C may be formed of a lateral bezel structure (or "lateral member") 218 which is combined with the front plate 202 and the rear plate 211 and includes a metal and/or polymer. The rear plate 211 and the lateral bezel structure 218 may be integrally formed and may be of the same material (e.g., a metallic material such as aluminum).

The front plate 202 may include two first regions 210D disposed at long edges thereof, respectively, and bent and extended seamlessly from the first surface 210A toward the rear plate 211. Similarly, the rear plate 211 may include two second regions 210E disposed at long edges thereof, respectively, and bent and extended seamlessly from the second surface 210B toward the front plate 202. The front plate 202 (or the rear plate 211) may include only one of the first regions 210D (or of the second regions 210E). The front plate 202 may not include the first region 210D and the second region 210E, and may only include a flat plane that is arranged parallel to the second surface 210B. When viewed from a lateral side of the electronic device 200, the lateral bezel structure 218 may have a first thickness (or width) on a lateral side where the first region 210D or the second region 210E is not included, and may have a second thickness, being less than the first thickness, on another lateral side where the first region 210D or the second region 210E is included.

The electronic device 200 may include at least one of a display 201 (e.g., a display 160 of FIG. 1), an input device 203 (e.g., an input module 150 of FIG. 1), a sound output devices 207 and 214 (e.g., a sound output module 155 of FIG. 1), sensor modules 204 and 219 (e.g., a sensor module 176 of FIG. 1), camera modules 205, 212, and 213 (e.g., a camera module 180 of FIG. 1), a key input device 217, an indicator (not shown), and connector 208 (e.g., a connection terminal 178 of FIG. 1). The electronic device 200 may omit at least one (e.g., the key input device 217 or the indicator) of the above components, or may further include other components.

The display 201 may be exposed through a substantial portion of the front plate 202, for example. At least a part of the display 201 may be exposed through the front plate 202 that forms the first surface 210A and the first region 210D of the lateral surface 210C. The display 201 may be combined with, or adjacent to, a touch sensing circuit, a pressure sensor capable of measuring the touch strength (pressure), and/or a digitizer for detecting a stylus pen. At least a part of the sensor modules 204 and 219 and/or at least a part of the key input device 217 may be disposed in the first region 210D and/or the second region 210E.

The input device 203 may include a microphone. In some embodiments, the input device 203 may include a plurality of microphones arranged to sense the direction of the sound. The sound output devices 207 and 214 may include speakers. The speakers may include an external speaker 207 and a receiver 214 for a call. In some embodiments, the microphone, the speakers, and the connector 208 are disposed in the space of the electronic device 200 and may be exposed to the external environment through at least one hole formed in the housing 210. In some embodiments, a hole formed in the housing 210 may be used in common for the microphone and speakers. In some embodiments, the sound output devices may include a speaker (e.g., a piezo speaker) that operates while excluding a hole formed in the housing 210.

The sensor modules 204 and 219 may generate electrical signals or data corresponding to an internal operating state of the electronic device 200 or to an external environmental condition. The sensor modules 204 and 219 may include a first sensor module 204 (e.g., a proximity sensor) and/or a second sensor module (e.g., a fingerprint sensor) disposed on the first surface 210A of the housing 210, and/or a third sensor module 219 (e.g., a heart rate monitor (HRM) sensor). The fingerprint sensor may be disposed on the first surface 210A (e.g., the display 201) of the housing 210. A fingerprint sensor (e.g., an ultrasonic or optical fingerprint sensor) may be disposed below the display 201 on the first surface 210A. The electronic device 200 may further include at least one of a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 200, and a second camera device 212, and/or a flash 213 disposed on the second surface 210B. The camera modules 205 and 212 may include one or more lenses, an image sensor, and/or an image signal processor. The flash 213 may include, for example, a light emitting diode or a xenon lamp. Two or more lenses (e.g., wide angle and telephoto lenses) and image sensors may be disposed on one side of the electronic device 200.

The key input device 217 may be disposed on the lateral surface 210C of the housing 210. The electronic device 200 may not include some or all of the key input device 217 described above, and the key input device 217 which is not included may be implemented in another form such as a soft key on the display 201. The key input device 217 may include the sensor module disposed on the second surface 210B of the housing 210. In another embodiment, the key input device 217 may be implemented using a pressure sensor included in the display 201.

The indicator (not shown) may be disposed on the first surface 210A of the housing 210. For example, the indicator may provide status information of the electronic device 200 in an optical form. The indicator (e.g., a light emitting device) may provide a light source associated with the operation of the camera module 205. The indicator may include, for example, a light emitting diode (LED), an infrared (IR) LED, or a xenon lamp.

The connector hole 208 may include a connector hole adapted for a connector (e.g., a universal serial bus (USB) connector) for transmitting and receiving power and/or data to and from an external electronic device and/or a connector hole adapted for a connector (e.g., an earphone jack) for transmitting and receiving an audio signal to and from an external electronic device.

Some camera module 205 of camera modules 205 and 212, some sensor module 204 of sensor modules 204 and 219, or an indicator may be arranged to be exposed through a display 201. For example, the camera module 205, the sensor module 204, or the indicator may be arranged in the internal space of an electronic device 200 so as to be brought into contact with an external environment through an opening of the display 201, which is perforated up to a front plate 202. The area facing the camera module 205 of the display 201 may be formed as a transparent area having a designated transmittance as a part of an area displaying content. The transmissive region may have a transmittance ranging from about 5% to about 20%. Such a transmissive region may include a region overlapping an effective region (e.g., an angle of view region) of the camera module 205 through which light for generating an image by being imaged by an image sensor passes. For example, the transparent area of the display 201 may include an area having a lower pixel density or wiring density or both than the surrounding area. For example, the transmissive area may replace the aforementioned opening. The camera module 205 may include an under display camera (UDC). Some sensor module 204 may be arranged to perform their functions without being visually exposed through the display 201 in the internal space of the electronic device 200. For example, in this case, an area of the display 201 facing the sensor module may not require a perforated opening.

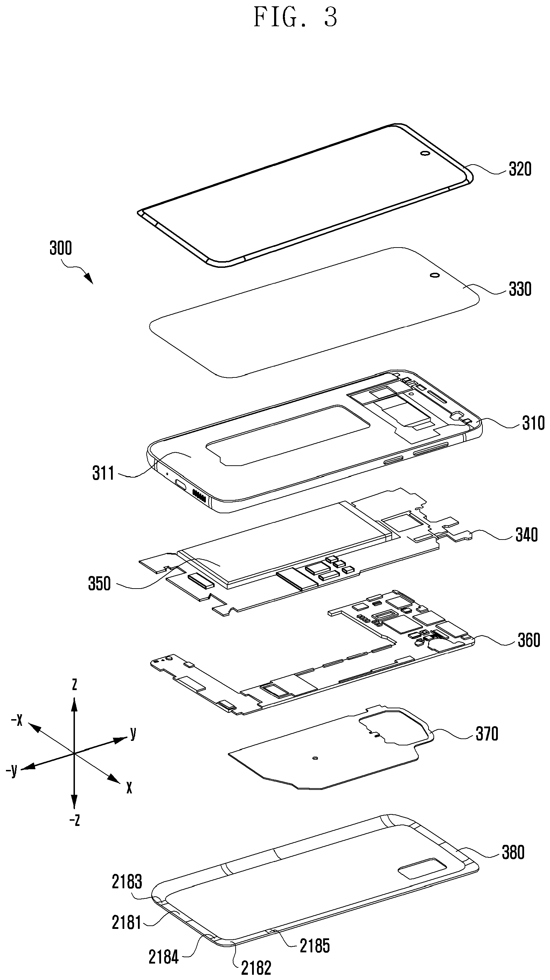

According to various embodiments, the electronic device 200 may include an antenna formed through at least a portion of a conductive member included in the side member 218. For example, the antenna may be formed by electrically connecting at least one conductive portion 2181 and 2182 segmented through at least one non-conductive portion 2183, 2184, and 2185 disposed on the side member 218 to a wireless communication circuit (e.g., a wireless communication module 192 of FIG. 1). For example, a first conductive portion 2181 may be segmented through a first non-conductive portion 2183 and a second non-conductive portion 2184 spaced apart by a specified interval, and may be electrically connected to a wireless communication circuit (e.g., a wireless communication module 192 of FIG. 1) disposed on a substrate (e.g., a printed circuit board 340 of FIG. 3). The first conductive portion 2181 is disposed to be segmented through the first non-conductive portion 2183 and the third non-conductive portion 2185, and can be electrically connected to a wireless communication circuit (e.g., a wireless communication module 192 of FIG. 1) disposed on a substrate (e.g., a printed circuit board 340 of FIG. 3).

FIG. 3 illustrates an exploded perspective view showing an electronic device 300 according to an embodiment of the disclosure.

The electronic device 300 shown in FIG. 3 may be similar, at least in part, to the electronic device 101 in FIG. 1, or to the electronic device 200 in FIGS. 2A and 2B, may further include another embodiment of the electronic device.

Referring to FIG. 3, an electronic device 300 may include a lateral bezel structure 310, a first support member 311 (e.g., a bracket or a support structure), a front plate 320 (e.g., a front cover), a display 330, a printed circuit board (PCB) 340, a battery 350, a second support member 360 (e.g., a rear case), an antenna 370, and a rear plate 380 (e.g., a rear cover). The electronic device 300 may omit at least one (e.g., the first support member 311 or the second support member 360) of the above components or may further include another component. Some components of the electronic device 300 may be the same as or similar to those of the electronic device 200 shown in FIG. 2A or FIG. 2B, thus, descriptions thereof are omitted below.

The first support member 311 is disposed inside the electronic device 300 and may be connected to, or integrated with, the lateral bezel structure 310. The first support member 311 may be formed of, for example, a metallic material and/or a non-metal (e.g., polymer) material. The first support member 311 may be combined with the display 330 at one side thereof and also combined with the printed circuit board (PCB) 340 at the other side thereof. On the PCB 340, a processor (e.g., a processer 120 of FIG.1), a memory (e.g., a memory 130 of FIG. 1), and/or an interface (e.g., an interface 177 of FIG. 1) may be mounted.

The processor may include, for example, one or more of a central processing unit (CPU), an application processor (AP), a graphics processing unit (GPU), an image signal processor (ISP), a sensor hub processor, or a communications processor (CP).

The memory may include, for example, one or more of a volatile memory (e.g., a volatile memory 132 of FIG. 1) and a non-volatile memory (e.g., a non-volatile memory 134 of FIG. 1).

The interface may include, for example, a high definition multimedia interface (HDMI), a USB interface, a secure digital (SD) card interface, and/or an audio interface. The interface may electrically or physically connect the electronic device 300 with an external electronic device and may include a USB connector, an SD card/multimedia card (MMC) connector, or an audio connector.

The battery 350 (e.g., a battery 189 of FIG. 1) is a device for supplying power to at least one component of the electronic device 300, and may include, for example, a non-rechargeable primary battery, a rechargeable secondary battery, or a fuel cell. At least a part of the battery 350 may be disposed on substantially the same plane as the PCB 340. The battery 350 may be integrally disposed within the electronic device 300. The battery 350 may be detachably disposed from the electronic device 300.

The antenna 370 may be positioned between the rear plate 380 and the battery 350. The antenna 370 may include, for example, a near field communication (NFC) antenna, a wireless charging antenna, and/or a magnetic secure transmission (MST) antenna. The antenna 370 may perform short-range communication with an external device, or transmit and receive power required for charging wirelessly. An antenna structure may be formed by a part or combination of the lateral bezel structure 310 and/or the first support member 311.

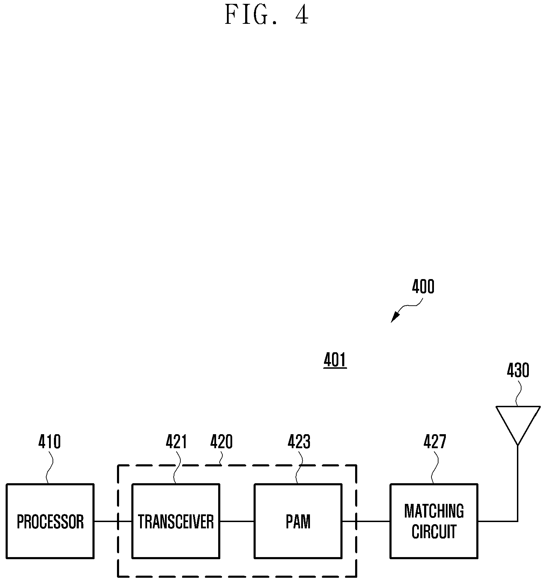

Hereinafter, FIG. 4 is a block diagram 400 of an electronic device 401 according to various embodiments.

Referring to FIG. 4, an electronic device 401 (e.g., the electronic device 101 of FIG. 1, the electronic device 200 of FIGS. 2A and 2B, and the electronic device 300 of FIG. 3) may include a processor 410 (e.g., the processor 120 of FIG. 1), a wireless communication circuit 420 (e.g., the wireless communication module 192 of FIG. 1), a matching circuit 427, and/or an antenna 430.

According to various embodiments, the processor 410 (e.g., the processor 120 of FIG. 1) may perform overall control operations of the electronic device 401 and may control wireless transmission and reception operations.

In an embodiment, although not shown, the processor 410 may include an application processor (e.g., the main processor 121 of FIG. 1) and a communication processor (e.g., the coprocessor 123 of FIG. 1) that is operable independently of or in conjunction with the application processor. For example, the processor 410 may control a transceiver 421 by using the communication processor. The processor 410 may control the operation of the transceiver 421 to generate a wireless signal (e.g., a transmission signal). The processor 410 may determine a wireless signal to be radiated through the antenna 430 by using the transceiver 421. The processor 410 may determine a frequency of the wireless signal for the antenna 430.

According to various embodiments, the wireless communication circuit 420 (e.g., the wireless communication module 192 of FIG. 1) may transmit and receive wireless signals (e.g., RF signals). The wireless communication circuit 420 may include the transceiver 421 and/or a power amplifier module (PAM) 423.

In an embodiment, the transceiver 421 may perform modulation of a wireless signal to be transmitted or demodulation of a received wireless signal. In an embodiment, the PAM 423 may amplify the modulated wireless signal or the demodulated wireless signal. The PAM 423 may separate and filter the amplified transmission and reception wireless signals, and deliver the transmission signal to the antenna 430. The PAM 423 may deliver the reception signal, which is received through the antenna 430, to the transceiver 421.

According to various embodiments, the matching circuit 427 may perform impedance matching of the wireless signal transmitted to the antenna 430. In an embodiment, the matching circuit 427 may include a tunable IC that may selectively use one of a plurality of passive elements (e.g., capacitors and/or inductors).

In various embodiments, although not shown, the electronic device 401 may include a memory (e.g., the memory 130 of FIG. 1) operatively connected to the processor 410. The memory 130 may store at least one instruction for controlling the matching circuit 427, based on receiving a wireless signal from the transceiver 421.

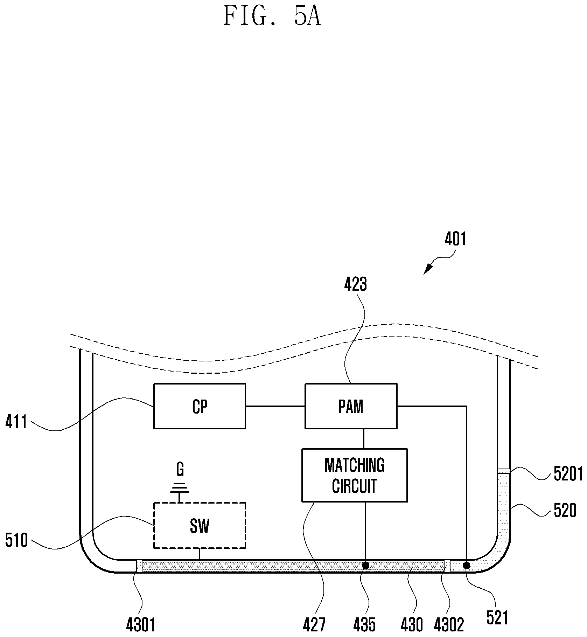

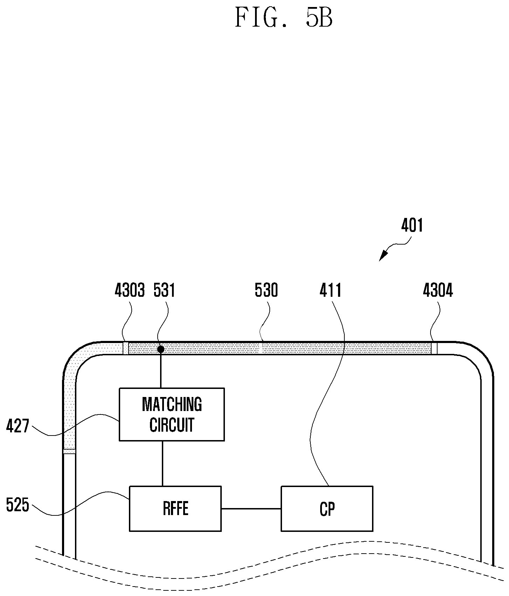

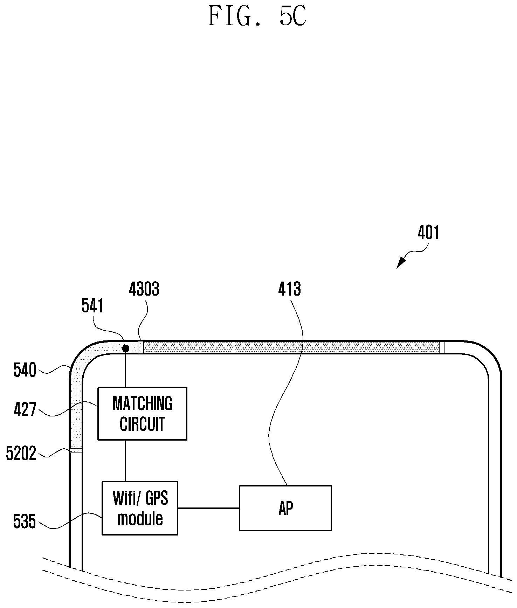

FIGS. 5A, 5B, and 5C illustrate examples of arrangement of a matching circuit according to various embodiments.

Referring to FIG. 5A, an electronic device (e.g., the electronic device 401 of FIG. 4) may include a housing (e.g., the housing 210 of FIG. 2A) that includes a first surface (or a front surface) (e.g., the first surface 210A of FIG. 2A), a second surface (or a rear surface) (e.g., the second surface 210B of FIG. 2B), and a side surface (e.g., the side surface 210C of FIG. 2A) that encloses a space between the first surface 210A and the second surface 210B.

In various embodiments, the electronic device 401 may include a substrate (e.g., the printed circuit board 340 of FIG. 3) disposed in an inner space of the housing 210). The substrate 340 may include a communication processor (e.g., the coprocessor 123 of FIG. 1, the processor 410 of FIG. 4), the PAM 423, and/or the matching circuit 427 disposed thereon. The communication processor 411, the PAM 423, and/or the matching circuit 427 disposed on the substrate 340 may be electrically connected via an electrical path.

**In** various embodiments, the electronic device 401 may include an antenna formed via at least a portion of a conductive member included in a side surface member (e.g., the side surface member 218 of FIG. 2A). For example, the antenna may be formed by electrically connecting the at least one conductive portion 430 and 520, segmented via at least one non-conductive portion 4301, 4302, and 5201 disposed on the side surface member 218, to a wireless communication circuit (e.g., the wireless communication circuit 420 of FIG. 4), e.g., the PAM 423. For example, the first conductive portion 430 (e.g., the first conductive portion 2181 of FIGS. 2A, 2B, and 3) may be arranged to be segmented via a first non-conductive portion 4301 (e.g., the first non-conductive portion 2183 of FIGS. 2A, 2B, and 3) and a second non-conductive portion 4302 (e.g., the second non-conductive portion 2184 of FIGS. 2A, 2B, and 3) spaced apart at designated intervals. The first conductive portion 430 may be electrically connected to the wireless communication circuit 420, e.g., the PAM 423, disposed on the substrate 340.

In an embodiment, the first conductive portion 430 (e.g., a feeding point 435 of the first conductive portion 430) may be electrically connected to the wireless communication circuit 420, e.g., the PAM 423, and thus may operate as an antenna radiator. In an embodiment, the wireless communication circuit 420 may be configured to transmit and/or receive a wireless signal in a first designated frequency band (e.g., a low band (e.g., about 600 MHz to 900 MHz) and a mid-band (e.g., about 1700 MHz to 2200 MHz) via the first conductive portion 430.

In an embodiment, one end of the first conductive portion 430 may be electrically connected with a switch unit 510. The switch unit 510 may be electrically connected to a ground G of the substrate 340. The switch unit 510 may adjust the length of the frequency band of the wireless signal transmitted and/or received through the first conductive portion 430.

In an embodiment, the second conductive portion 520 (e.g., the second conductive portion 2182 of FIGS. 2A, 2B, and 3) may be arranged to be segmented through the second non-conductive portion 4302 and the third non-conductive portion 5201 (e.g., the third non-conductive portion 2185 of FIGS. 2A, 2B, and 3). The second conductive portion 520 (e.g., a feeding point 521 of the second conductive portion 520) may be electrically connected to the wireless communication circuit 420, e.g., the PAM 423, disposed on the substrate 340. In an embodiment, the wireless communication circuit 420 may be configured to transmit and/or receive a wireless signal in a second designated frequency band (e.g., a high band (e.g., about 2.5 GHz to 2.6 GHz) or NR band (e.g., about 3.5 GHz)) via the second conductive portion 520.

In an embodiment, the PAM 423 may amplify a wireless signal modulated or a wireless signal demodulated by the transceiver (e.g., the transceiver 421 of FIG. 4), separate and filter the amplified transmitted and received signals, and deliver the same to the first conductive portion 430 or the second conductive portion 520.

In an embodiment, the matching circuit 427 may perform impedance matching of a wireless signal transmitted through the first conductive portion 430. In various embodiments, the matching circuit 427 may include a tunable IC that may selectively utilize one of a plurality of passive elements (e.g., a capacitor and/or an inductor).

At least one of the elements of the electronic device of FIGS. 5B and 5C described below may be the same as or similar to at least one of the elements of the electronic device of FIG. 5A described above, and redundant descriptions will be omitted hereinafter.

Referring to FIG. 5B, the substrate 340 may include a communication processor 411 (e.g., the coprocessor 123 of FIG. 1, the processor 410 of FIG. 4), a radio frequency front end (RFFE) 525, and/or matching circuit 427 disposed thereon. The communication processor 411, the RFFE 525, and/or the matching circuit 427 disposed on the substrate 340 may be electrically connected via an electrical path.

In various embodiments, the electronic device 401 may include an antenna formed via at least a portion of a conductive member included in the side surface member (e.g., the side surface member 218 of FIG. 2A). For example, the antenna may be formed by electrically connecting a third conductive portion 530 (e.g., a feeding point 531 of the third conductive portion 530) to the RFFE 525, wherein the third conductive portion is segmented through at least one non-conductive portion 4303, 4304 disposed on the side surface member 218. For example, the third conductive portion 530 may be arranged to be segmented through a fourth non-conductive portion 4303 and a fifth non-conductive portion 4304 spaced apart at designated intervals. The third conductive portion 530 may be electrically connected to the RFFE 525 disposed on the substrate 340.

In an embodiment, the matching circuit 427 may be disposed between the RFFE 525 and the third conductive portion 530 to perform impedance matching of wireless signals transmitted through the third conductive portion 530.

Referring to FIG. 5C, the substrate 340 of the electronic device 401 may include an application processor 413 (e.g., the main processor 121 of FIG. 1, the processor 410 of FIG. 4), a Wi-Fi/GPS module 535, and/or a matching circuit 427 disposed thereon. The application processor 413, the Wi-Fi/GPS module 535, and/or the matching circuit 427, which are disposed on the substrate 340, may be electrically connected via an electrical path.

In various embodiments, the electronic device 401 may include an antenna formed via at least a portion of a conductive member included in a side surface member (e.g., the side surface member 218 of FIG. 2A). For example, the antenna may be formed by electrically connecting a fourth conductive portion 540 (e.g., a feeding point 541 of the fourth conductive portion 540) to the Wi-Fi/GPS module 535, wherein the fourth conductive portion is segmented through at least one non-conductive portion 4303, 5202 disposed on the side surface member 218. For example, the fourth conductive portion 540 may be arranged to be segmented through the fourth non-conductive portion 4303 and the sixth non-conductive portion 5202 spaced apart at designated intervals. The fourth conductive portion 540 may be electrically connected to the Wi-Fi/GPS module 535 disposed on the substrate 340.

In an embodiment, the matching circuit 427 may be disposed between the Wi-Fi/GPS module 535 and the fourth conductive portion 540 to perform impedance matching of wireless signals for near field communication transmitted through the fourth conductive portion 540.

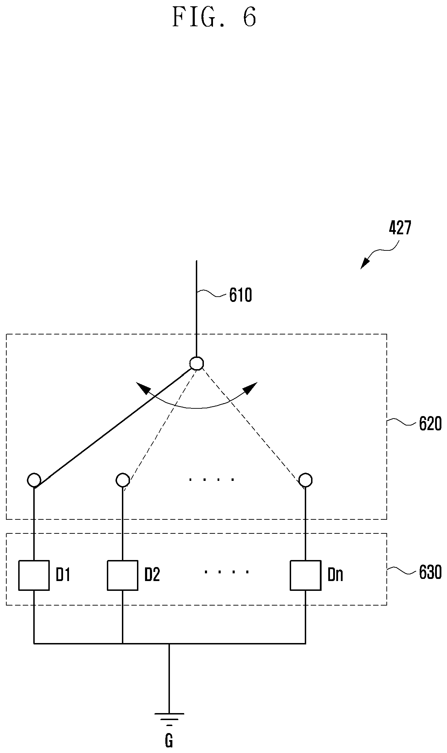

FIG. 6 is a configuration diagram of the matching circuit 427 according to various embodiments.

Referring to FIG. 6, the matching circuit 427 (e.g., a switching circuit) may include at least one switch 620 or a plurality of passive elements 630 (D1, D2, ..., Dn) having different element values and electrically connected to or electrically disconnected from a corresponding electrical path by the at least one switch 620. According to an embodiment, the plurality of passive elements 630 may include capacitors having various capacitance values and/or inductors having various inductance values. According to an embodiment, the matching circuit 427 may be connected to an electrical path 610 by means of an element having a designated element value under the control of a processor (e.g., the processor 410 of FIG. 4). In an embodiment, the matching circuit 427 may be disconnected from the corresponding electrical path 610 by means of the at least one switch 620. According to an embodiment, the at least one switch 620 may include a micro-electromechanical systems (MEMS) switch. According to an embodiment, the MEMS switch may have a complete turn on/off characteristic because it performs a mechanical switching operation by an internal metal plate and thus may not substantially effecting a change in the radiation characteristics of the antenna. In an embodiment, the at least one switch 620 may include a single pole single throw (SPST), a single pole double throw (SPDT), or a switch including three or more throws.

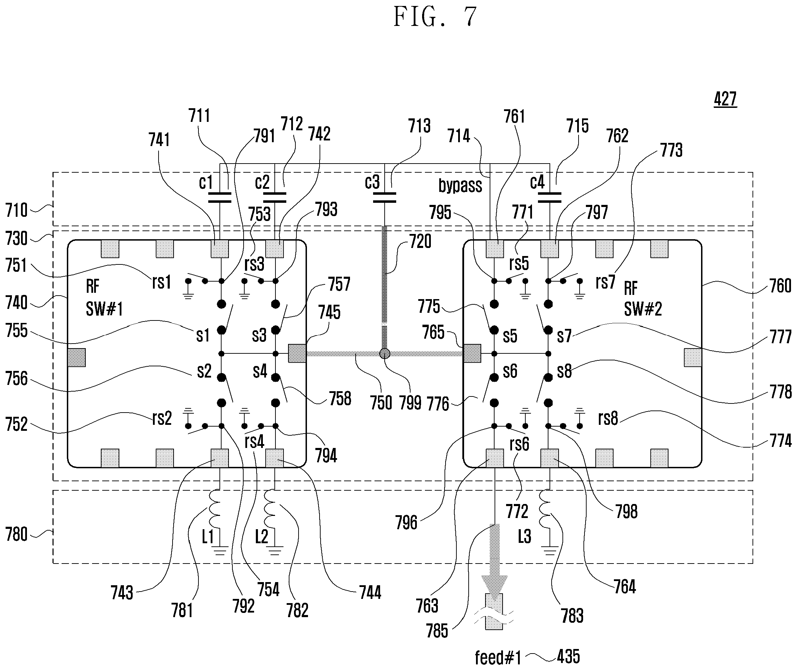

FIG. 7 specifically illustrates a matching circuit 427 according to various embodiments.

Referring to FIG. 7, the matching circuit 427 may be disposed between a wireless communication circuit (e.g., the wireless communication circuit 420 of FIG. 4) and an antenna (e.g., the antenna 430 of FIG. 4) (or the first conductive portion of FIG. 5A) to perform impedance matching of a wireless signal transmitted to the antenna 430.

In an embodiment, the matching circuit 427 may include a plurality of capacitors 710, a switching circuit 730, and/or a plurality of inductors 780.

In an embodiment, the plurality of capacitors 710 may include, but are not limited to, a first capacitor C1 711, a second capacitor C2 712, a third capacitor C3 713, and/or a fourth capacitor C4 715.

In an embodiment, the plurality of capacitors 710 may be disposed in parallel to each other.

In an embodiment, the switching circuit 730 may include a first switching circuit 740 and a second switching circuit 760. The switching circuit 730 may include, but is not limited to, more than two switching circuits.

In an embodiment, each of the first switching circuit 740 and the second switching circuit 760 may include a plurality of terminals.

In an embodiment, the first switching circuit 740 and the second switching circuit 760 may be electrically connected via a first electrical path 750. For example, a fifth terminal 745 of the first switching circuit 740 and a fifth terminal 765 of the second switching circuit 760 may be electrically connected via the first electrical path 750.

In an embodiment, the first capacitor C1 711 may be connected to a 1-1st node 791 via a first terminal 741 of the first switching circuit 740. The second capacitor C2 712 may be connected to a 1-3rd node 793 via a second terminal 742 of the first switching circuit 740.

In an embodiment, one of the plurality of capacitors 710, e.g., the third capacitor C3 713, may be connected to the first electrical path 750 (e.g., a third node 799 on the first electrical path 750) via the second electrical path 720.

In an embodiment, a bypass line 714 may be connected to a 2-1st node 795 via a first terminal 761 of the second switching circuit 760. The fourth capacitor C4 715 may be connected to a 2-3rd node 797 via a second terminal 762 of the second switching circuit 760.

In an embodiment, the first terminal 741 and the second terminal 742 of the first switching circuit 740, and the first terminal 761 and the second terminal 762 of the second switching circuit 760 described above may be input ports, e.g., input ports to which a wireless signal is applied by a processor (e.g., the processor 410 of FIG. 4).

In an embodiment, the third capacitor C3 713 that is connected to the first electrical path 750 via the second electrical path 720, among the plurality of capacitors 710, may have a fixed value (e.g., an αpF value). Each of the remaining capacitors, e.g., the first capacitor C1 711, the second capacitor C2 712, and the fourth capacitor C4 715, except for the third capacitor C3 713 among the plurality of capacitors 710, may have a variable value.

In an embodiment, each of the plurality of capacitors, e.g., the first capacitor C1 711, the second capacitor C2 712, the third capacitor C3 713, and the fourth capacitor C4 715, may have a different time constant value.

In an embodiment, the plurality of inductors 780 may include, but are not limited to a first inductor L1 781, a second inductor L2 782, and/or a third inductor L3 783.

In an embodiment, the plurality of inductors 780 may be disposed in parallel to each other.

In an embodiment, a third terminal 743 and a fourth terminal 744 of the first switching circuit 740, and a third terminal 763 and a fourth terminal 764 of the second switching circuit 760 may be output ports, and one of the outports may be connected to the feeding point 435 of the antenna 430. For example, the third terminal 763 of the second switching circuit 760 may be connected to the feeding point 435 of the antenna 430 via a third electrical path 785.

In an embodiment, although not shown, an inductor (or capacitor) may be additionally connected to the remaining at least one output port. For example, the first inductor L1 781 may be connected between a 1-2nd node 792 and a ground via the third terminal 743 of the first switching circuit 740. The second inductor L2 782 may be connected between a 1-4th node 794 and a ground via the fourth terminal 744 of the first switching circuit 740. The third inductor L3 783 may be connected between a 2-4th node 798 and a ground via the fourth terminal 764 of the second switching circuit 760. The processor 410 may utilize the first inductor L1 781, the second inductor L2 782, and the third inductor L3 783 as shunt impedance elements.

**In** an embodiment, the first switching circuit 740 may include a plurality of first switching elements, e.g., a 1-1st switching element rs1 751, a 1-2nd switching element rs2 752, a 1-3rd switching element rs3 753, and/or a 1-4th switching element rs4 754 that switch the connection with the ground. For example, the first switching circuit 740 may include a first switching element rs1 751 connected to the 1-1st node 791 to switch the connection with the ground, a 1-2nd switching element rs2 752 connected to a 1-2nd node 792 to switch the connection with the ground, a 1-3rd switching element rs3 753 connected to the 1-3rd node 793 to switch the connection with the ground, and/or a 1-4th switching element rs4 754 connected to the 1-4th node 794 to switch the connection with the ground.

In an embodiment, the first switching circuit 740 may include a plurality of second switching elements, e.g., a 2-1st switching element s1 755 and a 2-2nd switching element s2 756 that switch the connection between the first capacitor C1 711 and the first inductor L1 781, and a 2-3rd switching element s3 757 and/or a 2-4th switching element s4 758 that switch the connection between the second capacitor C2 712 and the second inductor L2 782. For example, the first switching circuit 740 may include a 2-1st switching element s1 755 connected between the 1-1st node 791 and the third node 799, and a 2-2nd switching element s2 756 connected between the 1-2nd node 792 and the third node 799, a 2-3rd switching element s3 757 connected between the 1-3rd node 793 and the third node 799, and/or a 2-4th switching element s4 758 connected between the 1-4th node 794 and the third node 799.

In an embodiment, the second switching circuit 760 may include a plurality of first switching elements, e.g., a 1-5th switching element rs5 771, a 1-6th switching element rs6 772, a 1-7th switching element rs7 773, and/or a 1-8th switching element rs8 774 that switch the connection with the ground. For example, the second switching circuit 760 may include a 1-5th switching element rs5 771 connected to the 2-1st node 795 to switch the connection with the ground, a 1-6th switching element rs6 772 connected to the 2-2nd node 796 to switch the connection with the ground, a 1-7th switching element rs7 773 connected to the 2-3rd node 797 to switch the connection with the ground, and a 1-8th switching element rs8 774 connected to the 2-4th node 798 to switch the connection with the ground.

**In** an embodiment, the second switching circuit 760 may include a plurality of second switching elements, e.g., a 2-5th switching element s5 775 and a 2-6th switching element s6 776 that switch the connection between the bypass line 714 and the feeding point 435 of the first conductive portion 430, and a 2-7th switching element s7 777 and a 2-8th switching element s8 778 that switch the connection between the fourth capacitor C4 715 and the third inductor L3 783. For example, the second switching circuit 760 may include the 2-5th switching element s5 775 connected between the 2-1st node 795 and the third node 799, and the 2-6th switching element s6 776 connected between the 2-2nd node 796 and the third node 799, the 2-7th switching element s7 777 connected between the 2-3rd node 797 and the third node 799, and/or the 2-8th switching element s8 778 connected between the 2-4th node 798 and the third node 799.

In various embodiments, when a wireless signal is input, the processor 410 may apply the wireless signal to at least one capacitor of the plurality of capacitors 710 and control on/off the plurality of first switching elements and/or the plurality of second switching elements included in the first switching circuit 740 and/or the second switching circuit 760, respectively. By controlling on/off the plurality of first switching elements and/or the plurality of second switching elements, the processor may enable the plurality of first switching elements and/or the plurality of second switching elements to operate as series variable capacitors and/or shunt variable capacitors. Accordingly, when performing impedance matching of a wireless signal, various capacitor values may be obtained, so that when the first conductive part 430 operates as an antenna radiator, the frequency-variable range can be enlarged.

In various embodiments, the switching circuit 730 may be configured by a single package including the first switching circuit 740 and the second switching circuit 760. It is not limited thereto, and respective switching elements included in the first switching circuit 740 and the second switching circuit 760 may be configured separately.

In various embodiments, it has been described, but not limited to, that the on/off of the plurality of first switching elements and/or the plurality of second switching elements included in the first switching circuit 740 and/or the second switching circuit 760, respectively, is controlled by the processor 410. The on/off of the plurality of first switching elements and/or the plurality of second switching elements included in the first switching circuit 740 may be controlled by the first switching circuit 740, and the on/off of the plurality of first switching elements and/or the plurality of second switching elements included in the second switching circuit 760 may be controlled by the second switching circuit 760.

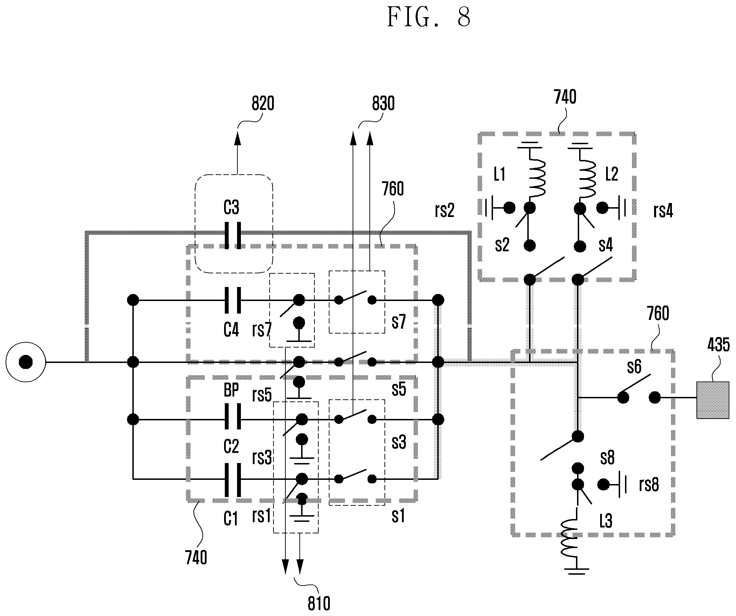

FIG. 8 illustrates an operation of a matching circuit 427 according to various embodiments.

Referring to FIG. 8, the matching circuit 427 may include a plurality of capacitors (e.g., a first capacitor C1, a second capacitor C2, a third capacitor C3 820, and a fourth capacitor C4), switching circuits (e.g., a first switching circuit 740 and a second switching circuit 760), and/or a plurality of inductors (e.g., a first inductor L1, a second inductor L2, and a third inductor L3).

In an embodiment, a 1-1st switching element rs1, a 1-2nd switching element rs2, a 1-3rd switching element rs3, a 1-4th switching element rs4, a 1-5th switching element rs5, a 1-6th switching element rs6, a 1-7th switching element rs7, and a 1-8th switching element rs8 included in the first switching circuit 740 and the second switching circuit 760 may be associated with a parallel switch. For example, the processor (e.g., the processor 410 of FIG. 4) may control on/off of at least one switching element among the 1-1st switching element rs1, the 1-2nd switching element rs2, the 1-3rd switching element rs3, the 1-4th switching element rs4, the 1-5th switching element rs5, the 1-6th switching element rs6, the 1-7th switching element rs7, and the 1-8th switching element rs8 so as to enable the matching circuit 427 to operate as a shunt variable capacitor.

In an embodiment, a 2-1st switching element s1, a 2-2nd switching element s2, a 2-3rd switching element s3, a 2-4th switching element s4, a 2-5th switching element s5, a 2-6th switching element s6, a 2-7th switching element s7, and a 2-8th switching element s8 included in the first switching circuit 740 and the second switching circuit 760 may be associated with a serial switch. For example, a processor (e.g., the processor 410 of FIG. 4) may control the on/off of at least one switching element among the 2-1st switching element s1, the 2-2nd switching element s2, the 2-3rd switching element s3, the 2-4th switching element s4, the 2-5th switching element s5, the 2-6th switching element s6, the 2-7th switching element s7, and the 2-8th switching element s8 so as to enable the matching circuit 427 to operate as a series variable capacitor.

In an embodiment, the first capacitor C1, the second capacitor C2, and the fourth capacitor C4 may have a variable value, and the third capacitor C3 820 may have a fixed value. For example, the third capacitor C3 820 may have a fixed value of αpF and in this case, a total variable range may be a value from about αpF to about αpF+βpF (e.g., β = a value of the first capacitor C1 + a value of the second capacitor C2 + a value of the fourth capacitor C4).

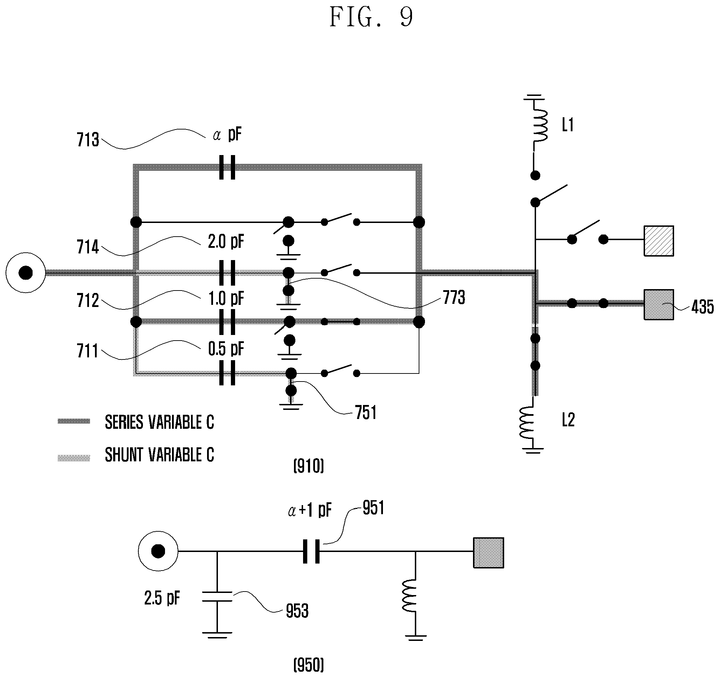

FIG. 9 illustrates an operation of the matching circuit 427 according to various embodiments.

Referring to FIG. 9, in an embodiment, a third capacitor 713 among a plurality of capacitors 710 may have a fixed value, and each of the first capacitor 711, the second capacitor 712, and the fourth capacitor 714 may have a variable value.

For example, in FIG. 9 according to various embodiments, the first capacitor 711 may have a value of 0.5 pF, the second capacitor 712 may have a value of 1.0 pF, the third capacitor 713 may have a value of αpF, and the fourth capacitor 714 may have a value of 2.0 pF.

Values of each of the capacitors described above according to various embodiments are provided as an embodiment for ease of explanation of the disclosure, and are not limited to the values described above.

In an embodiment, as shown reference numeral <910>, the processor (e.g., the processor 410 of FIG. 4) may, when a wireless signal is input, apply the wireless signal to at least one of the first capacitor 711, the second capacitor 712, the third capacitor 713, and the fourth capacitor 714.

Referring to FIG. 9 according to various embodiments, it is explained under an assumption that a wireless signal is applied to the first capacitor 711 and the fourth capacitor 714 among the first capacitor 711, the second capacitor 712, the third capacitor 713, and the fourth capacitor 714.

In an embodiment, when a wireless signal is input, the processor 410 may apply the wireless signal to the first capacitor 711 and the fourth capacitor 714. Based on applying the wireless signal, the processor 410 may control the 1-1st switching element rs1 751 connected to the first capacitor 711 and the 1-7th switching element rs7 773 connected to the fourth capacitor 714 to be turned on (e.g., enter into a short state). In this case, the input signal may be transferred to the feeding point 435 of the first conductive portion 430 via an electrical path electrically connected to the second capacitor 712 having a value of 1.0 pF and the third capacitor 713 having a value of αpF.

Accordingly, as shown in reference numeral <950>, a series capacitor 951 may have a value of (α+1)pF, and a shunt capacitor 953 may have a value of (2+0.5)pF.

In various embodiments, the processor 410 may determine an impedance matching value for a wireless signal, based on (α+1)pF, which is the value of the series capacitor 951, and (2+0.5)pF, which is the value of the shunt capacitor 953.

In various embodiments, upon input of a wireless signal, the processor 410 may enable the matching circuit 427 to operate as a series and a shunt variable capacitor by controlling the on or off of a plurality of first switching elements and a plurality of second switching elements included in switching circuits (e.g., the first switching circuit 740, the second switching circuit 760) , respectively. Accordingly, when the first conductive portion 430 operates as an antenna radiator, the frequency-variable range may be enlarged to enable communication corresponding to various resonant frequencies to be performed.

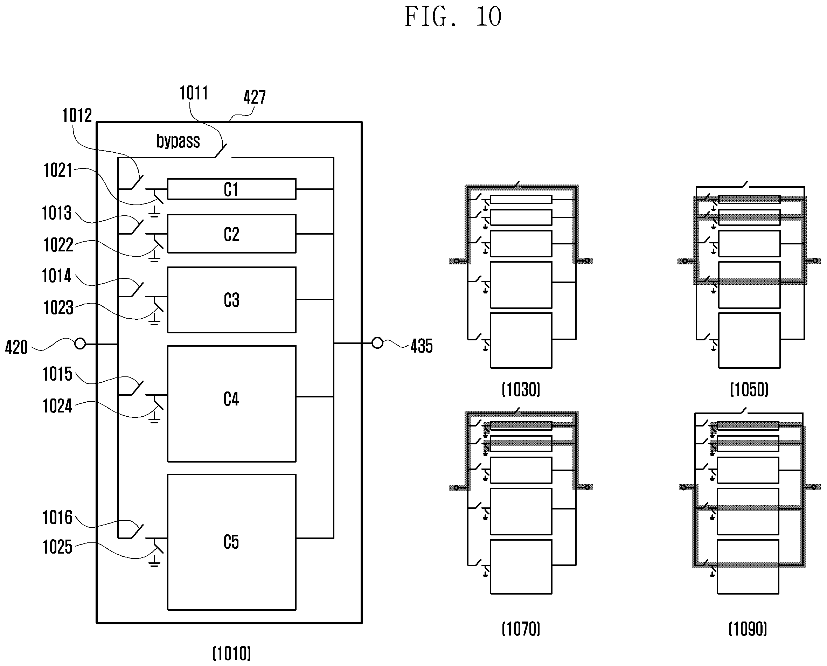

FIG. 10 schematically illustrates a configuration of a series capacitor and/or a shunt capacitor according to various embodiments.

Referring now to FIG. 10, as shown in reference numeral <1010>, the electronic device (e.g., the electronic device 401 of FIG. 4) may include a matching circuit (e.g., the matching circuit 427 of FIG. 4) disposed between the wireless communication circuit (e.g., the wireless communication circuit 420 of FIG. 4) and the feeding point 435 of the first conductive portion (e.g., the first conductive portion 430 of FIG. 5A). The matching circuit 427 may perform operating-frequency band transition through impedance matching when the first conductive portion 430 operates as an antenna radiator.

In an embodiment, the matching circuit 427 may include a plurality of capacitors (e.g., a first capacitor C1, a second capacitor C2, a third capacitor C3, a fourth capacitor C4, and a fifth capacitor C5) that switch the connection between the wireless communication circuit 420 and the feeding point 435 of the first conductive portion 430, a plurality of switching circuits 1012, 1013, 1014, 1015, and 1016 connected in series and controlling the application of a wireless signal to the plurality of capacitors, and a plurality of switching circuits 1021, 1022, 1023, 1024, and 1025 connected in parallel and controlling the connection between a bypass line and a ground.

In an embodiment, as shown in reference numeral <1030>, when the matching circuit 427 is operating in a bypass mode, if a wireless signal is input, the processor (e.g., the processor 410 of FIG. 4) may control a switching element 1011 disposed on the bypass line to be turned on (e.g., enter into a short state). The input signal may be delivered to the feeding point 435 of the first conductive portion 430 via the bypass line. In this case, the first conductive portion 430 may be caused to operate with a predetermined impedance when operating as an antenna radiator.

In an embodiment, as shown in reference numeral <1050>, when a wireless signal is input, the processor 410 may control the switching circuits 1012, 1013, 1015 to be turned on (e.g., enter into a short state) so that the wireless signal is applied to at least two capacitors, e.g., the first capacitor C1, the second capacitor C2, and the fourth capacitor C4. By controlling the switching circuits 1012, 1013, 1015 of the first capacitor C1, the second capacitor C2, and the fourth capacitor C4 to be turned on (e.g., enter into a short state), the matching circuit 427 may operate as a series variable capacitor. As the serial connection state of the first capacitor C1, second capacitor C2, and fourth capacitor C4 changes into a parallel connection state, the matching circuit may have various capacitance values.

In an embodiment, as shown in reference numeral <1070>, when a wireless signal is input, the processor 410 may control the switching circuits 1012, 1013, 1014, 1015, 1016 connected in series to be turned off and control at least one switching circuit 1021 and 1022 among the plurality of switching circuits connected in parallel to be turned on (e.g., enter into a short state) to prevent the wireless signal from being applied to the plurality of capacitors C1, C2, C3, C4, and C5. In this case, the input signal may be delivered to the ground via the bypass line by a parallel-connected switch in the on state to the feeding point 435 of the first conductive portion 430. Accordingly, the matching circuit 427 may operate as a shunt variable capacitor.

In an embodiment, as shown in reference numeral <1090>, when a wireless signal is input, the processor 410 may control the series-connected switching circuits 1015 and 1016 to be turned on (e.g., enter into a short state) and control at least one switching circuit 1021 and 1022 among the plurality of switching circuits connected in parallel to be turned on (e.g., enter into a short state) to cause the wireless signal to be applied to at least one capacitor, e.g., the fourth capacitor C4 and the fifth capacitor C5. In this case, the input signal may be delivered to the ground by a series-connected switch in the on state and a parallel-connected switch in the on state to the feeding point 435 of the first conductive portion 430. Accordingly, the matching circuit 427 may operate as a series and a shunt variable capacitor.

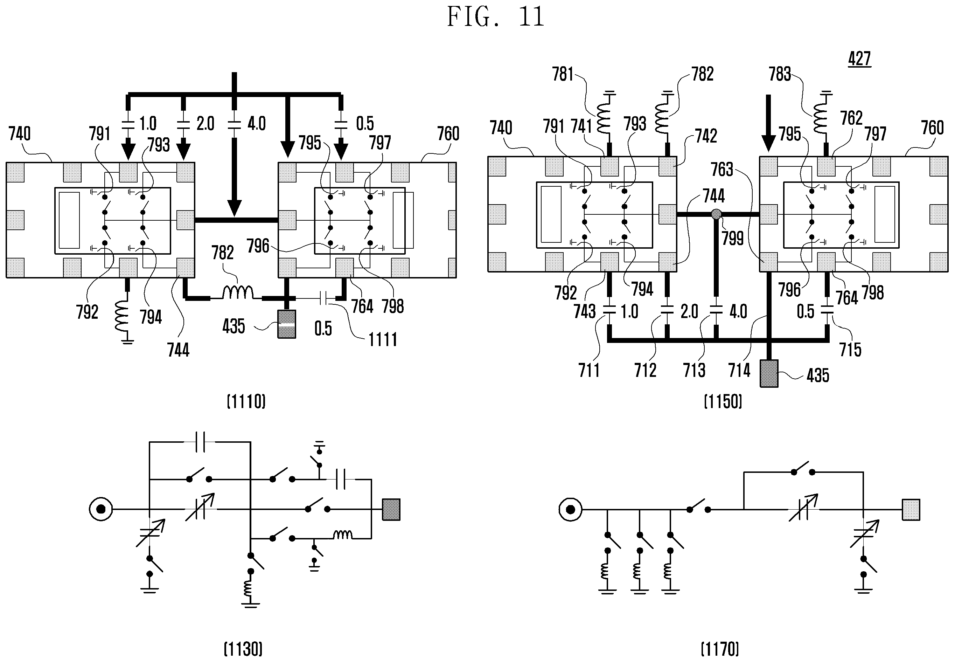

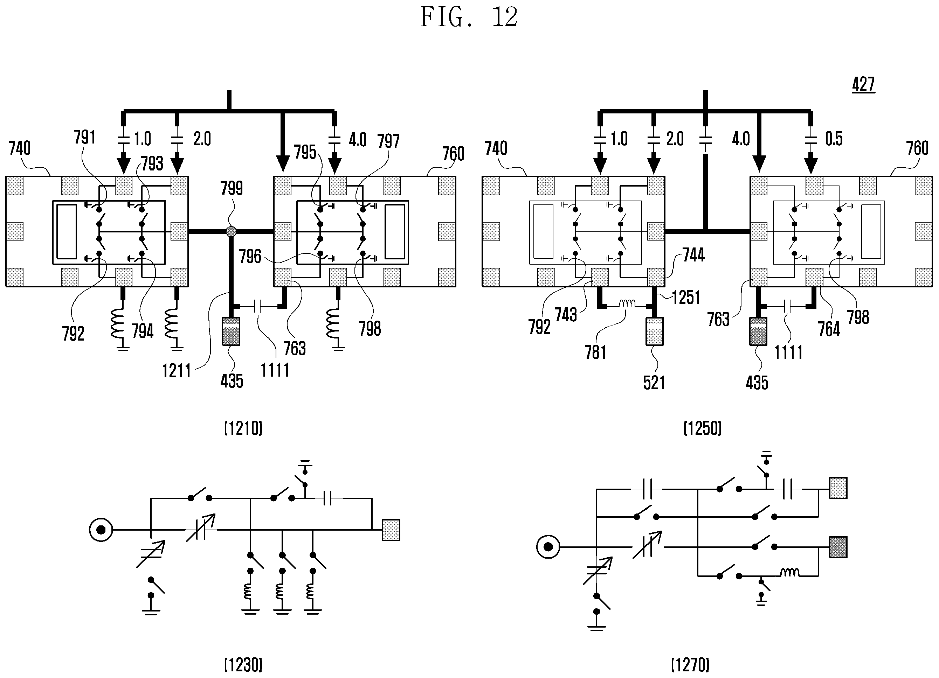

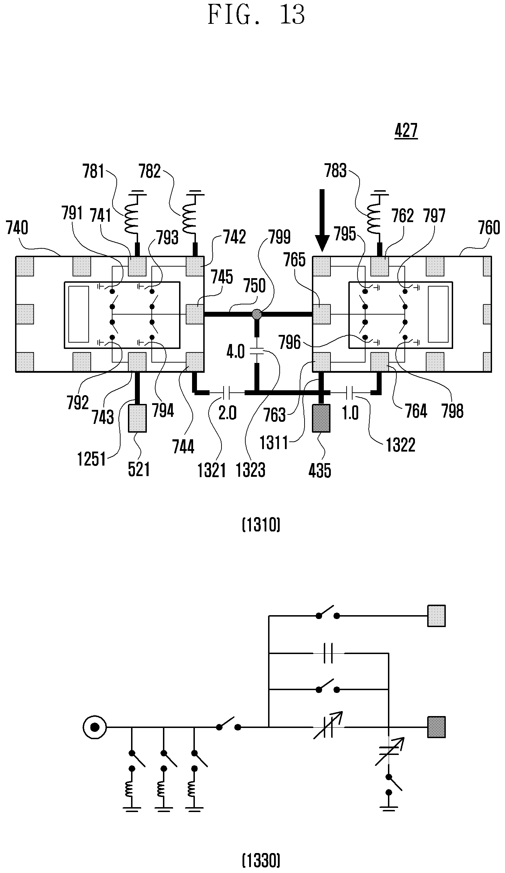

FIG. 11 is a configuration diagram of the matching circuit 427 according to various embodiments, FIG. 12 is a configuration diagram of the matching circuit 427 according to various embodiments, and FIG. 13 is a configuration diagram of the matching circuit 427 according to various embodiments.

FIGS. 11, 12, and 13 according to various embodiments are drawings illustrating various embodiments of the matching circuit 427 having a different configuration from the configuration of the matching circuit 427 of FIG. 7 described above.

FIGS. 11, 12, and 13 according to various embodiments may be similar to the configuration of FIG. 7 described above, and descriptions that are redundant to the configuration of FIG. 7 may be omitted below.

Referring now to FIG. 11, as shown in reference numeral <1110>, the matching circuit 427 may be configured such that, as compared to the matching circuit 427 of FIG. 7, the second inductor 782 may be connected between the 1-4th node 794 and the feeding point 435 of the first conductive portion 430 via the fourth terminal 744 of the first switching circuit 740. A fifth capacitor 1111, instead of the third inductor 783, may be connected between the 2-4th node 798 and the feeding point 435 of the first conductive portion 430 via the fourth terminal 764 of the second switching circuit 760. An equivalent circuit according to the configuration of the reference numeral <1110> may be as shown in reference numeral <1130>.

In an embodiment, referring to reference numeral <1150>, the matching circuit 427 may have a configuration such that, as compared to the matching circuit 427 of FIG. 7, the positions of the plurality of capacitors 710 and the positions of the plurality of inductors 780 are changed. For example, the plurality of capacitors may be connected to a third terminal 743 and a fourth terminal 744 of the first switching circuit 740, and a third terminal 763 and a fourth terminal 764 of the second switching circuit 760, respectively, which are output ports. For example, the first capacitor C1 711 may be connected between the 1-2nd node 792 and the feeding point 435 of the first conductive portion 430 via the third terminal 743 of the first switching circuit 740. The second capacitor C2 712 may be connected between the 1-4th node 794 and the feeding point 435 of the first conductive portion 430 via the fourth terminal 744 of the first switching circuit 740. The third capacitor C3 713 may be connected between the third node 799 on the first electrical path (e.g., the first electrical path 750 of FIG. 7) and the feeding point 435. The bypass line 714 may be connected between the 2-2nd node 796 and the feeding point 435 via the third terminal 763 of the second switching circuit 760. The fourth capacitor C4 715 may be connected between the 2-4th node 798 and the feeding point 435 via the fourth terminal 764 of the second switching circuit 760.

In an embodiment, the plurality of inductors may be connected to a first terminal 741 and a second terminal 742 of the first switching circuit 740 and a second terminal 762 of the second switching circuit 760, respectively, which are input ports. For example, the first inductor L1 781 may be connected between the 1-1st node 791 and the ground via the first terminal 741 of the first switching circuit 740. The second inductor L2 782 may be connected between the 1-3rd node 793 and the ground via the second terminal 742 of the first switching circuit 740. The third inductor L3 783 may be connected between the 2-3rd node 797 and the ground via the second terminal 762 of the second switching circuit 760. An equivalent circuit according to the configuration of reference numeral <1150> may be as shown in reference numeral <1170>.

The range, step, insertion loss (IL), and/or number of parallel ports of the series variable capacitors and shunt variable capacitors according to reference numerals <1110>, <1130>, <1150>, and <1170> according to various embodiments, may be as shown in Table 1 below.

In an embodiment, when assuming that the variable capacitor changes within a range of, e.g., approximately 0.5 pF to 8 pF, "step" may refer to a unit of variation. For example, when the variable capacitor changes among values approximate to 0.5 pF, 1.0 pF, 1.5 pF, 2.0 pF, ..., 8.0 pF, the "step" may have a value of approximately 0.5 pF. In an embodiment, the step may be determined as the smallest value of the plurality of capacitors, e.g., the first capacitor C1, the second capacitor C2, the third capacitor C3, the fourth capacitor C4, and the fifth capacitor C5. In other words, the value of the step may depend on the capacitor having the smallest value.

In an embodiment, the insertion loss IL may refer to power lost as current passes through the matching circuit 427.

In an embodiment, a parallel port may refer to the number of inductors connected in parallel to the remaining other terminals, excluding some of the terminals connected to the variable capacitor, among the plurality of terminals of the switching circuit (e.g., the first switching circuit 740 and the second switching circuit 760).

**[Table 1]**

| | | |
|---|---|---|
| Series variable capacitor | Range | Approximately 4.0 to 7.5 pF |
| | Step | Approximately 0.5 pF |
| | Insertion loss (IL) | Approximately 0.4 dB |
| Shunt variable capacitor | Range | Approximately 0.5 to 3.5 pF |
| | Step | Approximately 0.5 pF |
| Parallel port | 3 | |

Referring now to FIG. 12, as shown in reference numeral <1210>, the matching circuit 427 may be configured such that, as compared to the matching circuit 427 of FIG. 7, the first electrical path 750 (e.g., the third node 799 on the first electrical path) and the feeding point 435 of the first conductive portion 430 may be connected via the fourth electrical path 1211, instead of the third capacitor C3 713 and the first electrical path 750 being connected via the second electrical path 720. Further, the fifth capacitor 1111 may be connected between the second node 796 and the feeding point 435 of the first conductive portion 430 via the third terminal 763 of the second switching circuit 760. An equivalent circuit according to the configuration of reference numeral <1210> may be as shown in reference numeral <1230>.

The range, step, insertion loss (IL), and/or number of parallel ports of the series variable capacitors and shunt variable capacitors according to reference numerals <1210> and <1230> according to various embodiments may be as shown in Table 2 below.

**[Table 2]**

| | | |
|---|---|---|
| Series variable capacitor | Range | Approximately 1.0 to 7.0 pF |
| | Step | Approximately 1.0 pF |
| | Insertion loss (IL) | Approximately 0.2 dB |
| Shunt variable capacitor | Range | Approximately 1.0 to 7.0 pF |
| | Step | Approximately 1.0 pF |
| Parallel port | | 3 |

In an embodiment, referring to reference numeral <1250>, the matching circuit 427 may be configured such that, as compared to the matching circuit 427 of FIG. 7, the fifth capacitor 1111, instead of the third inductor 783, may be connected to the fourth terminal 764 of the second switching circuit 760, and the fifth capacitor 1111 may be connected to the feeding point 435 of the first conductive portion 430. For example, the fifth capacitor 1111 may be connected between the 2-4th node 798 and the feeding point 435 of the first conductive portion 430 via the fourth terminal 764 of the second switching circuit 760. Additionally, the fourth terminal 744 of the first switching circuit 740 may be connected to the feeding point 521 of the second conductive portion (e.g., the feeding point 521 of the second conductive portion 520 of FIG. 5A) via a fourth electrical path 1251. The first inductor 781 may be connected between the 1-2nd node 792 and the feeding point 521 of the second conductive portion 520 via the third terminal 743 of the first switching circuit 740. An equivalent circuit according to the configuration of reference numeral <1250> may be as shown in reference numeral <1270>.

The range, step, insertion loss (IL), and/or number of parallel ports of the series variable capacitors and shunt variable capacitors according to reference numerals <1250> and <1270> according to various embodiments may be as shown in Table 3 below.

**[Table 3]**

| | | |
|---|---|---|
| Series variable capacitor | Range | Approximately 4.0 to 7.5 pF |
| | Step | Approximately 0.5 pF |
| | Insertion loss (IL) | Approximately 0.4 dB |
| Shunt variable capacitor | Range | Approximately 0.5 to 3.5 pF |
| | Step | Approximately 0.5 pF |
| Parallel port | | 2 |

Referring to FIG. 13, as shown in reference numeral <1310>, the matching circuit 427 may be configured such that, as compared to the matching circuit 427 of FIG. 7, the plurality of inductors may be connected to the first terminal 741 and the second terminal 742 of the first switching circuit 740 and the second terminal 762 of the second switching circuit 760, respectively, which are input ports. For example, the first inductor L1 781 may be connected between the 1-1st node 791 and the ground via the first terminal 741 of the first switching circuit 740. The second inductor L2 782 may be connected between the 1-3rd node 793 and the ground via the second terminal 742 of the first switching circuit 740. The third inductor L3 783 may be connected between the 2-3rd node 797 and the ground via the second terminal 762 of the second switching circuit 760. In addition, the third terminal 743 of the first switching circuit 740 may be connected to the second feeding point 521 of the second conductive portion 520 via the fourth electrical path 1251. For example, the 1-2nd node 792 may be connected to the second feeding point 521 of the second conductive portion 520 via the third terminal 743 of the first switching circuit 740 and the fourth electrical path 1251. The third terminal 763 of the second switching circuit 760 may be connected to the feeding point 435 of the first conductive portion 430 via the fifth electrical path 1311. A capacitor 1321 (e.g., a capacitor having a value of 2.0 pF) may be connected between the 1-4th node 794 and the feeding point 435 of the first conductive portion 430 via the fourth terminal 744 of the first switching circuit 740. A capacitor 1322 (e.g., a capacitor having a value of 1.0 pF) may be connected between the 2-4th node 798 and the feeding point 435 of the first conductive portion 430 via the fourth terminal 764 of the second switching circuit 760. A capacitor 1323 (e.g., a capacitor having a value of 4.0 pF) may be connected between the third terminal 799 and the feeding point 435 of the first conductive portion 430. The first electrical path 750 connecting the fifth terminal 745 of the first switching circuit 740 and the fifth terminal 765 of the second switching circuit 760 may be connected to a path between the capacitor 1321 connected to the fourth terminal 744 of the first switching circuit 740 and the feeding point 435 of the first conductive portion 430. An equivalent circuit according to the configuration of reference numeral <1310> may be as shown in reference numeral <1330>.

The range, step, insertion loss (IL), and/or number of parallel ports of the series variable capacitors and shunt variable capacitors according to reference numerals <1310> and <1330> according to various embodiments may be as shown in Table 4 below.

**[Table 4]**

| | | |
|---|---|---|
| Series variable capacitor | Range | Approximately 4.0 to 7.0 pF |
| | Step | Approximately 1.0 pF |
| | Insertion loss (IL) | Approximately 0.4 dB |
| Shunt variable capacitor | Range | Approximately 1.0 to 3.0 pF |
| | Step | Approximately 1.0 pF |
| Parallel port | | 3 |

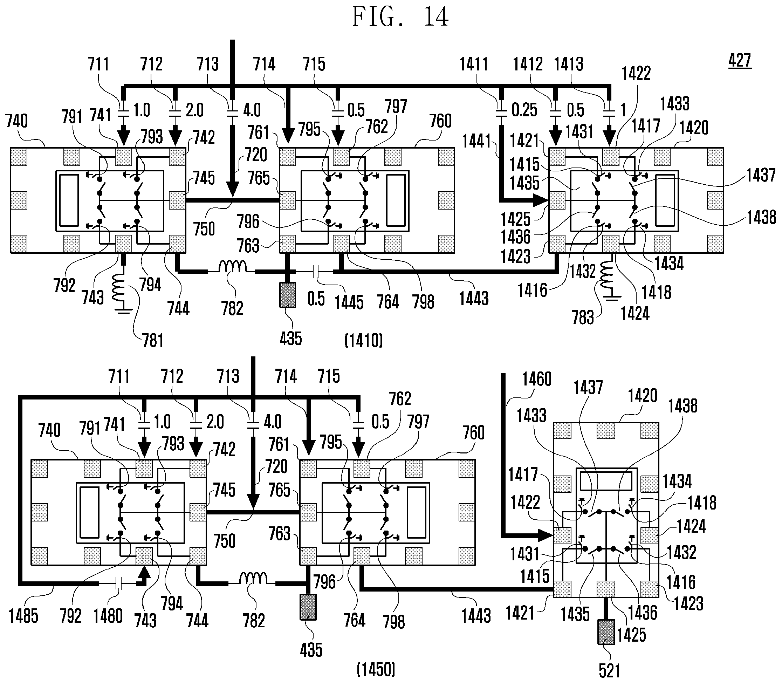

In FIGS. 7, 8, 9, 10, 11, 12, and 13 according to various embodiments, the switching circuit 730 has been described as including the first switching circuit 740 and the second switching circuit 760, but is not limited thereto. For example, the switching circuit 730 may include more than two switching circuits. This will be described in various embodiments with reference to FIG. 14 below.

FIG. 14 illustrates a matching circuit 427 according to various embodiments.

Referring to FIG. 14, as shown in reference numeral <1410>, the matching circuit 427 may include a plurality of capacitors, switching circuit, and/or a plurality of inductors.

In an embodiment, the plurality of capacitors may include a first capacitor C1 711, a second capacitor C2 712, a third capacitor C3 713, a fourth capacitor C4 715, a fifth capacitor C5 1411, a sixth capacitor C6 1412, and/or a seventh capacitor 1413. In an embodiment, the plurality of capacitors may be disposed in parallel to each other. In an embodiment, each of the first capacitor C1 711, the second capacitor C2 712, the third capacitor C3 713, the fourth capacitor C4 715, the fifth capacitor C5 1411, the sixth capacitor C6 1412, and/or the seventh capacitor 1413 may have a variable value. In various embodiments, the first capacitor C1 711 may have a value of 1.0 pF, the second capacitor C2 712 may have a value of 2.0 pF, the third capacitor C3 713 may have a value of 4.0 pF, the fourth capacitor C4 715 may have a value of 0.5pF, the fifth capacitor C5 1411 may have a value of 0.25 pF, the sixth capacitor C6 1412 may have a value of 0.5 pF, and the seventh capacitor C7 1413 may have a value of 1 pF. In various embodiments, the values of capacitors according to reference numeral <1410> above are exemplary for ease of explanation of the disclosure and are not limited to the values described above.

In an embodiment, the switching circuit may include a first switching circuit 740, a second switching circuit 760, and a third switching circuit 1420.

In an embodiment, each of the first switching circuit 740, the second switching circuit 760, and the third switching circuit 1420 may include a plurality of terminals.

The configuration of the first switching circuit 740 and the second switching circuit 760 according to various embodiments may be similar to the configuration of FIG. 7 described above, and descriptions that are redundant to the configuration of FIG. 7 may be omitted herein.

In an embodiment, the first switching circuit 740, the second switching circuit 760, and the third switching circuit 1420 may be electrically connected. In various embodiments, the switching circuit may be configured by a single package that includes the first switching circuit 740, the second switching circuit 760, and the third switching circuit 1420, but is not limited thereto. Switching elements included in each of the first switching circuit 740, second switching circuit 760, and third switching circuit 1420 may be configured separately.

In an embodiment, the fifth capacitor C5 1411 may be electrically connected to a fifth terminal 1425 of the third switching circuit 1420 via a sixth electrical path 1441. The sixth capacitor C6 1412 may be electrically connected to a 4-1st node 1415 via the first terminal 1421 of the third switching circuit 1420. The seventh capacitor C7 1413 may be electrically connected to a 4-3rd node 1417 via the second terminal 1422 of the third switching circuit 1420).

In an embodiment, the first terminal 1421, the second terminal 1422, and the fifth terminal 1425 of the third switching circuit 1420 described above may be input ports, e.g., input ports to which a wireless signal is applied by the processor (e.g., the processor 410 of FIG. 4).

In an embodiment, the plurality of inductors may include a first inductor L1 781, a second inductor L2 782, and/or a third inductor L3 783. For example, the first inductor L1 781 may be connected to the third terminal 743 of the first switching circuit 740. One end of the second inductor L2 782 may be connected to the fourth terminal 744 of the first switching circuit 740, and the other end of the second inductor L2 782 may be connected to the feeding point 435 of the first conductive portion 430. The third inductor L3 783 may be connected to a fourth terminal 1424 of the third switching circuit 1420. For example, the first inductor L1 781 may be connected between the 1-2nd nodes 792 and the ground, via the third terminal 743 of the first switching circuit 740. The second inductor L2 782 may be connected between the 1-4th node 794 and the feeding point 435 of the first conductive portion 430 via the fourth terminal 744 of the first switching circuit 740. The third inductor L3 783 may be connected between a 4-4th node 1418 and the ground via a fourth terminal 1424 of the third switching circuit 1420.

In an embodiment, the third terminal 743 and the fourth terminal 744 of the first switching circuit 740, the third terminal 763 and the fourth terminal 764 of the second switching circuit 760, a third terminal 1423 and a fourth terminal 1424 of the third switching circuit 1420 may be output ports, and at least one outport port among them may be connected to the feeding point 435 of the first conductive portion 430. For example, the third terminal 763 of the second switching circuit 760 may be connected to the feeding point 435 of the first conductive portion 430. In another example, the fourth terminal 764 of the second switching circuit 760 may be connected to the feeding point 435 of the first conductive portion 430 under the control of an eighth capacitor 1445. The third terminal 1423 of the third switching circuit 1420 may be connected to the eighth capacitor 1445 via a seventh electrical path 1443, and may be connected to the feeding point 435 of the first conductive portion 430 under the control of the eighth capacitor 1445.

In an embodiment, the third switching circuit 1420 may include a plurality of first switching elements, e.g., a 1-9th switching element 1431, a 1-10th switching element 1432, a 1-11th switching element 1433, and/or a 1-12th switching element 1434 that switch the connection with the ground. For example, the third switching circuit 1420 may include a 1-9th switching element 1431 connected to the 4-1st node 1415 to switch the connection with the ground, a 1-10th switching element 1432 connected to a 4-2nd node 1416 to switch the connection with the ground, a 1-11th switching element 1433 connected to the 4-3rd node 1417 to switch the connection with the ground, and/or a 1-12th switching element 1434 connected to the 4-4th node 1418 to switch the connection with the ground.

**In** an embodiment, the third switching circuit 1420 may include a plurality of second switching elements, e.g., a 2-9th switching element 1435 and a 2-10th switching element 1436 that switch the connection of the sixth capacitor C6 1412 and the eighth capacitor 1445, and a 2-11th switching element 1437 and a 2-12th switching element 1438 that switch the connection of the seventh capacitor C7 1413 and the third inductor L3 783. For example, the third switching circuit 1420 may include the 2-9th switching element 1435 and the 2-10th switching element 1436, which are connected between the 4-1st node 1415 and the 4-2nd node 1416 to switch the connection of the sixth capacitor C6 1412 and the eighth capacitor 1445, and the 2-11th switching element 1437 and the 2-12th switching element 1438, which are connected between the 4-3rd node 1417 and the 4-4th node 1418 to switch the connection of the seventh capacitor C7 1413 and the third inductor L3 783.

In various embodiments, when a wireless signal is input, the processor 410 may apply the wireless signal to at least one of the plurality of capacitors and control the on/off of the plurality of first switching elements and/or the plurality of second switching elements included in the first switching circuit 740, the second switching circuit 760, and/or the third switching circuit 1420. By controlling the on/off of the plurality of first switching elements and/or the plurality of second switching elements, various capacitor values may be obtained when performing impedance matching of the wireless signal.

In an embodiment, referring to reference numeral <1450>, the matching circuit 427 may include a plurality of capacitors, switching circuit, and/or a plurality of inductors.

In an embodiment, the plurality of capacitors may include a first capacitor C1 711, a second capacitor C2 712, a third capacitor C3 713, and/or a fourth capacitor C4 715. In an embodiment, the plurality of capacitors may be disposed in parallel to each other. In an embodiment, each of the first capacitor C1 711, the second capacitor C2 712, the third capacitor C3 713, and the fourth capacitor C4 715 may have a variable value. In various embodiments, the first capacitor C1 711 may have a value of 1.0 pF, the second capacitor C2 712 may have a value of 2.0 pF, the third capacitor C3 713 may have a value of 4.0 pF, and the fourth capacitor C4 75 may have a value of 0.5 pF. In various embodiments, the values of capacitors according to reference numeral <1450> above are exemplary for ease of explanation of the disclosure and are not limited to the values described above.

In an embodiment, the switching circuit may include a first switching circuit 740, a second switching circuit 760, and a third switching circuit 1420.

In an embodiment, each of the first switching circuit 740, the second switching circuit 760, and the third switching circuit 1420 may include a plurality of terminals.

The configuration of the first switching circuit 740 and the second switching circuit 760 according to various embodiments may be similar to the configuration of FIG. 7 described above, and descriptions that are redundant to the configuration of FIG. 7 may be omitted herein.

In an embodiment, the first switching circuit 740, the second switching circuit 760, and the third switching circuit 1420 may be electrically connected. For example, the fifth terminal 745 of the first switching circuit 740 and the fifth terminal 765 of the second switching circuit 760 may be electrically connected via a first electrical path 750. The fourth terminal 764 of the second switching circuit 760 and the first terminal 1421 of the third switching circuit 1420 may be connected via a seventh electrical path 1443.

In an embodiment, the first terminal 741 and the second terminal 742 of the first switching circuit 740, and the first terminal 761 and the second terminal 762 of the second switching circuit 760 may be input ports, e.g., input ports to which wireless signals are applied by the processor 410. However, they are not limited thereto.

For example, the second terminal 1422 of the third switching circuit 1420 may be connected to the processor (e.g., the processor 410 of FIG. 4) via the eighth electrical path 1460. In this case, the second terminal 1422 of the third switching circuit 1420 may also be an input port to which a wireless signal is applied by the processor 410.

In another example, the fifth capacitor 1480 may be connected to the third terminal 743 of the first switching circuit 740 via a ninth electrical path 1485. In this case, the third terminal 743 of the first switching circuit 740 may also be an input port to which a wireless signal is applied by the processor 410.

In an embodiment, the fourth terminal 744 of the first switching circuit 740, the third terminal 763 of the second switching circuit 760, and the fifth terminal 1425 of the third switching circuit 1420 may be output ports, and at least one port among them may be connected to the feeding point 435 of the first conductive portion 430. For example, the third terminal 763 of the second switching circuit 760 may be connected to the feeding point 435 of the first conductive portion 430, and the fifth terminal 1425 of the third switching circuit 1420 may be connected to the feeding point 521 of the second conductive portion 520.

In various embodiments, when a wireless signal is input, the processor 410 may apply the wireless signal to at least one capacitor of the plurality of capacitors and control the on/off of the plurality of first switching elements and/or the plurality of second switching elements included in the first switching circuit 740, the second switching circuit 760, and/or the third switching circuit 1420.

In an embodiment, a wireless signal input to the first switching element 740 and/or the second switching element 760 and processed by the control of the on/off of the plurality of first switching elements and/or the plurality of second switching elements may be delivered to the feeding point 435 of the first conductive portion 430. A wireless signal input to the first switching element 740 and/or the second switching element 760 and processed by the control of the on/off of the plurality of first switching elements and/or the plurality of second switching elements may be delivered to the feeding point 521 of the second conductive portion 520 via the seventh electrical path 1443. In other embodiments, a wireless signal input to a terminal of the third switching circuit 1420 and processed by the control of the on/off of the plurality of first switching elements and/or the plurality of second switching elements may be delivered to the feeding point 521 of the second conductive portion 520. A wireless signal input to a terminal of the third switching circuit 1420 and processed by the control of the on/off of the plurality of first switching elements and/or the plurality of second switching elements may be delivered to the feeding point 435 of the first conductive portion 430 via the seventh electrical path 1443.

In various embodiments, the processor 410 may be configured such that a wireless signal input to the first switching circuit 740, the second switching circuit 760, and/or the third switching element 1420 and processed by the control of the on/off of the plurality of first switching elements and/or the plurality of second switching elements may be delivered to a feeding point of the other conductive portion via a seventh electrical path 1443, thereby enlarging the frequency-variable range when the first conductive portion 430 or the second conductive portion 520 operates as an antenna radiator.

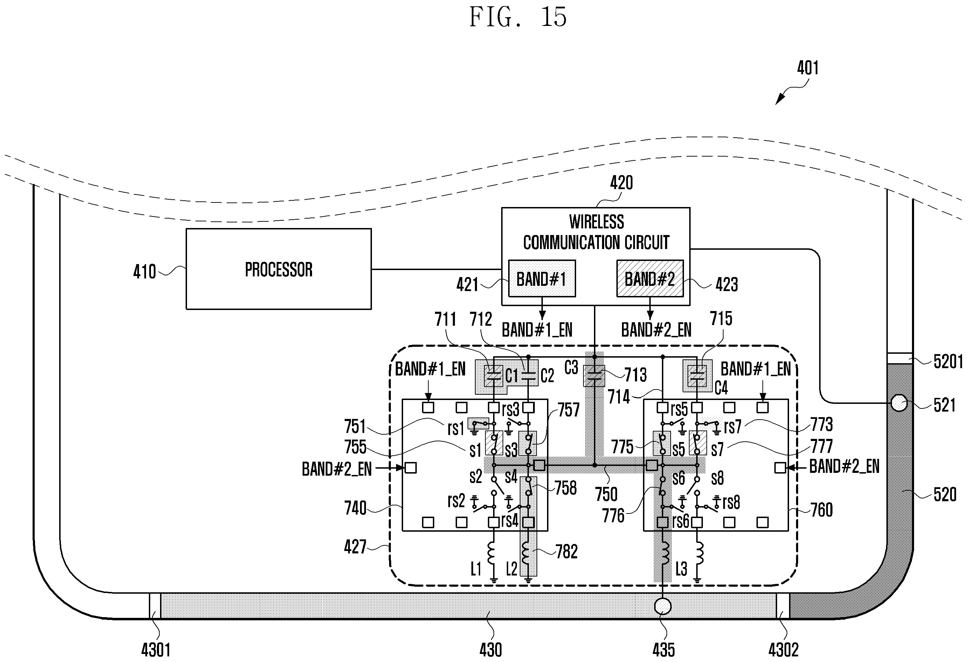

FIG. 15 illustrates an operation of the matching circuit 427 according to various embodiments.

Referring to FIG. 15, an electronic device (e.g., the electronic device 401 of FIG. 4) may include a housing (e.g., the housing 210 of FIG. 2A) that includes a first surface (or a front surface) (e.g., the first surface 210A of FIG. 2A), a second surface (or a rear surface) (e.g., the second surface 210B of FIG. 2B), and a side surface (e.g., the side surface 210C of FIG. 2A) that encloses a space between the first surface 210A and the second surface 210B.

In various embodiments, the electronic device 401 may include a substrate (e.g., the printed circuit board 340 of FIG. 3) disposed in an inner space of the housing 210). The substrate 340 may include a processor (e.g., the processor 410 of FIG. 4), a wireless communication circuit (e.g., the wireless communication circuit 420 of FIG. 4), and/or a matching circuit 427 disposed thereon. The processor 410, the wireless communication circuit 420, and/or the matching circuit 427 disposed on the substrate 340 may be electrically connected via an electrical path.

In various embodiments, the electronic device 401 may include an antenna formed via at least a portion of a conductive member included in a side surface member (e.g., the side surface member 218 of FIG. 2A). For example, the antenna may be formed by electrically connecting at least one conductive portion 430 and 520 to the wireless communication circuit 420 (e.g., the first wireless communication circuit 421 or the second wireless communication circuit 423 of FIG. 4), wherein the at least one conductive portion 430 and 520 is segmented through at least one non-conductive portion 4301, 4302, and 5201 disposed on the side surface member 218. For example, the first conductive portion 430 (e.g., the first conductive portion 2181 of FIGS. 2A, 2B, and 3) may be arranged to be segmented through a first non-conductive portion 4301 (e.g., the first non-conductive portion 2183 of FIGS. 2A, 2B, and 3 and a second non-conductive portion 4302 (e.g., the second non-conductive portion 2184 of FIGS. 2A, 2B, and 3) spaced apart at designated intervals. The first conductive portion 430 may be electrically connected to the wireless communication circuit 420 disposed on the substrate 340.

In an embodiment, the first conductive portion 430 (e.g., the feeding point 435 of the first conductive portion 430) may be electrically connected to the wireless communication circuit 420 to operate as an antenna radiator. In an embodiment, the wireless communication circuit 420 may be configured to transmit and/or receive a wireless signal in a first designated frequency band (e.g., a low band (e.g., about 600 MHz to 900 MHz) and a mid-band (e.g., about 1700 MHz to 2200 MHz)) via the first conductive portion 430.

In an embodiment, the second conductive portion 520 (e.g., the second conductive portion 2182 of FIGS. 2A, 2B, and 3) may be arranged to be segmented through the second non-conductive portion 4302 and the third non-conductive portion 5201 (e.g., the third non-conductive portion 2185 of FIGS. 2A, 2B, and 3). The second conductive portion 520 (e.g., the feeding point 521 of the second conductive portion 520) may be electrically connected to the wireless communication circuit 420 disposed on the substrate 340. In an embodiment, the wireless communication circuit 420 may be configured to transmit and/or receive a wireless signal in a second designated frequency band (e.g., a high band (e.g., about 2.5 GHz to 2.6 GHz) or an NR band (e.g., about 3.5 GHz)) via the second conductive portion 520.

In an embodiment, the matching circuit 427 may perform impedance matching of wireless signals transmitted through the first conductive portion 430.

In an embodiment, when a wireless signal is input, the processor 410 may apply the wireless signal to at least one of the first capacitor C1 711, the second capacitor C2 712, the third capacitor C3 713, and the fourth capacitor C4 715 included in the matching circuit 427.

In FIG. 15 according to various embodiments, it is assumed that when a wireless signal is input through a first frequency band (e.g., BAND#1) 421 of the wireless communication circuit 420, the wireless signal is applied to the first capacitor C1 711, the second capacitor C2 712, and the fourth capacitor C4 715 among the first capacitor C1 711, the second capacitor C2 712, the third capacitor C3 713, and the fourth capacitor C4 715. Additionally, it is assumed that when a wireless signal is input through a second frequency band (e.g., BAND#2) 423 of the wireless communication circuit 420, the wireless signal is applied to the first capacitor C1 711, the third capacitor C3 713, and the fourth capacitor C4 715 among the first capacitor C1 711, the second capacitor C2 712, the third capacitor C3 713, and the fourth capacitor C4 715.

In an embodiment, when a wireless signal is input through the first frequency band 421 of the wireless communication circuit 420, the processor 410 may apply the wireless signal to the first capacitor C1 711, the second capacitor C2 712, and the fourth capacitor C4 715. Based on applying the wireless signal, the processor 410 may control, to turn on (e.g., enter into a short state), a 1-1st switching element rs1 751 connected in parallel to the first capacitor C1 711, a 2-3rd switching element s3 757 and a 2-4th switching element s4 758 connected in series with the second capacitor C2 712, a 2-5th switching element s5 775 and a 2-6th switching element s6 776 connected in series with the bypass line 714, and 1-7th switching element rs7 773 connected in parallel to the fourth capacitor C4 715.

In this case, the input signal may be delivered to the ground by an on-state switch 751 connected in parallel to the first capacitor C1 711. Additionally, the input signal may be delivered to the ground by an on-state switch 773 connected in parallel to the fourth capacitor C4 C715. In addition, the input signal may be delivered to the ground by on-state switches 757 and 758 and a second inductor (e.g., second inductor 782 of FIG. 7) connected in series with the second capacitor C2 712. Additionally, the input signal may be delivered to the feeding point 435 of the first conductive portion 430 by on-state switches 775 and 776 connected in series with the bypass line 714.

In an embodiment, the processor 410 may determine an impedance matching value for the wireless signal based on a value of the series capacitor (e.g., a value of the second capacitor C2 712) and a value of the shunt capacitor (e.g., the sum of a value of the first capacitor C1 711 and a value of the fourth capacitor C4 715).

In an embodiment, when a wireless signal is input through the second frequency band 423 of the wireless communication circuit 420, the processor 410 may apply the wireless signal to the first capacitor C1 711, the third capacitor C3 713, and the fourth capacitor C4 715. Based on applying the wireless signal, the processor 410 may control the 2-1st switching element s1 755 connected in series with the first capacitor C1 711, the 2-6th switching element s6 776 connected in series with the bypass line 714, and the 2-7th switching element s7 777 connected in series with the fourth capacitor C4 715 to be turned on (e.g., enter into a short state).

In this case, the input signal delivered to the on-state switch 755 connected in series with the first capacitor C1 711 may be delivered to the feeding point 435 of the first conductive portion 430 via the first electrical path 750 (e.g., the first electrical path 750 of FIG. 7) by means of the 2-6th switching element s6 776 connected in series with the bypass line 714. In addition, the wireless signal applied to the third capacitor C3 713 may be delivered to the feeding point 435 of the first conductive portion 430 via the bypass line 714 by means of the on-state 2-6th switching element s6 776 connected in series with the bypass line 714. Further, the input signal delivered to the on-state switch 777 connected in series with the fourth capacitor C4 715 may be delivered to the feeding point 435 of the first conductive portion 430 by means of the on-state 2-6th switching element s6 776 connected in series with the bypass line 714.

In an embodiment, the processor 410 may determine an impedance matching value for the wireless signal, based on a value of the series capacitors (e.g., the sum of a value of the first capacitor C1 711, a value of the third capacitor C3 713, and a value of the fourth capacitor C4 715).

In various embodiments, upon input of a wireless signal, the processor 410 may control on or off of a plurality of first switching elements and a plurality of second switching elements included in switching circuits (e.g., the first switching circuit 740, the second switching circuit 760), respectively, thereby enabling the matching circuit 427 to operate as a series and/or shunt variable capacitor.

An electronic device (e.g., the electronic device 401 of FIG. 4) according to various embodiments may include a wireless communication circuit (e.g., the wireless communication circuit 420 of FIG. 4), an antenna (e.g., the antenna 430 of FIG. 4), a matching circuit (e.g., the matching circuit 427 of FIG. 4) disposed between the wireless communication circuit 420 and the antenna 430, and a processor (e.g., the processor 410 of FIG. 4) operatively connected to the wireless communication circuit 420, the antenna 430, and the matching circuit 427. The matching circuit 427 includes a first switching circuit 740 including a first switching element (e.g., the 1-1st switching element 751 of FIG. 7) that is connected to a 1-1st node 791 and switches the connection with the ground, a second switching element (e.g., the 2-1st switching element 755 of FIG. 7) connected between the 1-1st node 791 and a third node 799, a third switching element (e.g., the 1-2nd switching element 752 of FIG. 7) that is connected to the 1-2nd node 792 and switches the connection with the ground, a fourth switching element (e.g., the 2-2nd switching element 756 of FIG. 7) connected between the 1-2nd node 792 and the third node 799, a fifth switching element (e.g., the 1-3rd switching element 753 of FIG. 7) that is connected to a 1-3rd node 793 and switches the connection with the ground, a sixth switching element (e.g., the 2-3rd switching element 757 of FIG. 7) connected between the 1-3rd node 793 and the third node 799, a seventh switching element (e.g., the 1-4th switching element 754 of FIG. 7) that is connected to the 1-4th node 794 and switches the connection with the ground, and an eighth switching element (e.g., the 2-4th switching element 758 of FIG. 7) connected between the 1-4th node 794 and the third node 799, a second switching circuit 760 including a ninth switching element (e.g., the 1-5th switching element 771 of FIG. 7) that is connected to the 2-1st node 795 and switches the connection with the ground, a tenth switching element (e.g., the 2-5th switching element 775 of FIG. 7) connected between the 2-1st node 795 and the third node 799, an eleventh switching element (e.g., the 1-6th switching element 772 of FIG. 7) that is connected to the 2-2nd node 796 and switches the connection with the ground, a twelfth switching element (e.g., the 2-6th switching element 776 of FIG. 7) connected between the 2-2nd node 796 and the third node 799, a thirteenth switching element (e.g., the 1-7th switching element 773 of FIG. 7) that is connected to a 2-3rd node 797 and switches the connection with the ground, a fourteenth switching element (e.g., the 2-7th switching element 777 of FIG. 7) connected between the 2-3rd node 797 and the third node 799, a fifteenth switching element (e.g., the 1-8th switching element 774 of FIG. 7) that is connected to the 2-4th node 798 and switches the connection with the ground, and a sixteenth switching element (e.g., the 2-8th switching element 778 of FIG. 7) disposed between the 2-4th node 798 and the third node 799, a first inductor (e.g., the first inductor 781 of FIG. 7) connected between a 1-2nd node 792 and a ground, a second inductor (e.g., the second inductor 782 of FIG. 7) connected between a 1-4th node 794 and the ground, a third inductor (e.g., the third inductor 783 of FIG. 7) connected between a 2-4th node 798 and the ground, a first electrical path (e.g., the first electrical path 750 of FIG. 7) electrically connecting the first switching circuit 740 and the second switching circuit 760, a plurality of capacitors (e.g., the plurality of capacitors 710 of FIG. 7) disposed between the wireless communication circuit 420, the first switching circuit 740, and the second switching circuit 760, a second electrical path (e.g., the second electrical path 720 of FIG. 7) connecting the first electrical path 750 with one of the plurality of capacitors 710, a third electrical path (e.g., the third electrical path 785 of FIG. 7) connecting a 2-2nd node 796 and a feeding point of the antenna 430, and a bypass line (e.g., the bypass line 714 of FIG. 7) connected to the 2-1st node 795. The processor is configured to, in case that a wireless signal is input, apply the wireless signal to at least one of the plurality of capacitors 710, control to turn on or off the plurality of switching elements of the first switching circuit 740 and the plurality of switching elements of the second switching circuit 760, based on that the wireless signal is applied to the at least one capacitor, and enable the matching circuit 427 to operate as a series variable capacitor and a shunt variable capacitor, based on that the plurality of switching elements of the first switching circuit 740 and the plurality of switching elements of the second switching circuit 760 are controlled to be turned on or off.

In various embodiments, each of the first switching circuit 740 and the second switching circuit 760 includes a plurality of terminals.

In various embodiments, the plurality of capacitors 710 may include a first capacitor (e.g., the first capacitor 711 of FIG. 7), a second capacitor (e.g., the second capacitor 712 of FIG. 7), a third capacitor (e.g., the third capacitor 713 of FIG. 7), and a fourth capacitor (e.g., the fourth capacitor 715 of FIG. 7).

In various embodiments, the first capacitor 711 may be connected to the 1-1st node 791 through a first terminal (e.g., the first terminal 741 of FIG. 7) among the plurality of terminals of the first switching circuit 740, the second capacitor 712 may be connected to the 1-3rd node 793 through a second terminal (e.g., the first terminal 742 of FIG. 7) among the plurality of terminals of the first switching circuit 740, the third capacitor 713 may be connected to the third node 799 through the second electrical path 720, and the fourth capacitor 715 may be connected to the 2-3rd node 797 through a second terminal (e.g., the second terminal 762 of FIG. 7) among the plurality of terminals of the second switching circuit 760.

In various embodiments, the bypass line 714 may be connected to the 2-1st node 795 through a first terminal (e.g., the first terminal 761 of FIG. 7) among the plurality of terminals of the second switching circuit 760.

In various embodiments, the first terminal 741 and the second terminal 742 of the first switching circuit 740 and the first terminal 761 and the second terminal 762 of the second switching circuit 760 may be input ports to which a wireless signal is applied.

In various embodiments, the first inductor 781 may be connected to the 1-2nd node 792 through a third terminal (e.g., the third terminal 743 of FIG. 7) among the plurality of terminals of the first switching circuit 740, the second inductor 782 may be connected to the 1-4th node 794 through a fourth terminal (e.g., the fourth terminal 744 of FIG. 7) among the plurality of terminals of the first switching circuit 740, and the third inductor 783 may be connected to the 2-4th node 798 through a fourth terminal (e.g., the fourth terminal 764 of FIG. 7) among the plurality of terminals of the second switching circuit 760.

In various embodiments, a third terminal (e.g., the third terminal 763 of FIG. 7) of the plurality of terminals of the second switching circuit 760 may be connected to a feeding point (the feeding point 43 5 of FIG. 7) of the antenna 430 through a third electrical path (e.g., the third electrical path 785 of FIG. 7).

In various embodiments, the electronic device 401 may further include a second antenna (e.g., the second conductive portion 520 of FIG. 5A), wherein one of the 1-2nd node 792, the 1-4th node 794, and the 2-4th node 798 may be connected to a feeding point (the feeding point 521 of the second conductive portion 520 of FIG. 5A) of the second antenna instead of being connected to the first inductor 781, the second inductor 792, and the third inductor 793.

In various embodiments, the first switching element (e.g., the 1-1st switching element 751 of FIG. 7), the third switching element (e.g., the 1-2nd switching element 752of FIG. 7), the fifth switching element (e.g., the 1-3rd switching element 753 of FIG. 7), and the seventh switching element (e.g., the 1-4th switching element 754 of FIG. 7) of the first switching circuit 740 may be connected in parallel to the first terminal 741 and the second terminal 742 of the first switching circuit 740, and the second switching element (e.g., the 2-1st switching element 755 of FIG. 7), the fourth switching element (e.g., the 2-2nd switching element 756 of FIG. 7), the sixth switching element (e.g., the 2-3rd switching element 757 of FIG. 7), and the eighth switching element (e.g., the 2-4th switching element 758 of FIG. 7) of the first switching circuit 740 may be connected in series with the first terminal 741 and the second terminal 742 of the first switching circuit 740.

In various embodiments, the ninth switching element (e.g., the 1-5th switching element 771 of FIG. 7), the eleventh switching element (e.g., the 1-6th switching element 772 of FIG. 7), the thirteenth switching element (e.g., the 1-7th switching element 773 of FIG. 7), and the fifteenth switching element (e.g., the 1-8th switching element 774 of FIG. 7) of the second switching circuit 760 may be connected in parallel to the first terminal 761 and the second terminal 762 of the second switching circuit 760, and the tenth switching element (e.g., the 2-5th switching element 775 of FIG. 7), the twelfth switching element (e.g., the 2-6th switching element 776 of FIG. 7), the fourteenth switching element (e.g., the 2-7th switching element 777 of FIG. 7), and the sixteenth switching element (e.g., the 2-8th switching element 778 of FIG. 7) of the second switching circuit 760 may be connected in series with the first terminal 761 and the second terminal 762 of the second switching circuit 760.

In various embodiments, the first switching circuit 740 and the second switching circuit 760 may be configured as one package.

In various embodiments, switching elements included in each of the first switching circuit 740 and the second switching circuit 760 are configured separately.

In various embodiments, the processor 410 may be configured to, in case of operating in a bypass mode, deliver the wireless signal to the feeding point of the antenna 430 through the bypass line 714 to cause the antenna 430 to operate with a designated impedance.

In various embodiments, the processor 410 may be configured to, in case that the wireless signal is applied to at least one capacitor among the first capacitor 711, the second capacitor 712, or the fourth capacitor 714, control at least one switching element switching the connection between the at least one capacitor to which the wireless signal is applied and the ground to be turned on, and based on that the at least one switching element switching the connection between the at least one capacitor and the ground is controlled to be turned on, deliver the wireless signal to the feeding point of the antenna 430 so as to enable the matching circuit 427 to operate as the series variable capacitor.

In various embodiments, the processor 410 may be configured to, in case that the wireless signal is applied to at least one capacitor among the first capacitor 711, the second capacitor 712, or the fourth capacitor 714, control at least one switching element switching the connection between the at least one capacitor to which the wireless signal is applied and the ground to be turned off, control at least one switching element connected in series with the at least one capacitor to which the wireless signal is applied to be turned on, and control at least one other switching element switching the connection between the at least one other capacitor and the ground to be turned on and, based on that the at least one switching element switching the connection between the at least one capacitor to which the wireless signal is applied and the ground is controlled to be turned off, that the at least one switching element connected in series with the at least one capacitor to which the wireless signal is applied is controlled to be turned on, and that the at least one other switching element switching the connection between the at least one other capacitor and the ground is controlled to be turned on, deliver the wireless signal to the ground and the feeding point of the antenna by means of the at least one other switching element that is controlled to be turned on, so as to enable the matching circuit 427 to operate as the shunt variable capacitor.

In various embodiments, the processor 410 may be configured to, in case that the matching circuit 427 operates as the series variable capacitor and the shunt variable capacitor, determine an impedance matching value of the wireless signal, based on a value of the series variable capacitor and a value of the shunt variable capacitor.

In various embodiment, the one capacitor connected to the first electrical path 750 via the second electrical path 720 among the plurality of capacitors 710 may have a fixed value, and at least one remaining capacitor among the plurality of capacitors 710 may have a variable value.

In various embodiments, each of the plurality of capacitors may have a different time constant value.

In various embodiments, the wireless communication circuit 420 may be configured to transmit or receive a wireless signal through the antenna 430 in at least one of a low band or a mid-band frequency band.

Various embodiments disclosed in this specification and drawings are merely specific examples presented to facilitate explanation of the technical content of the disclosure and understanding of the disclosure, and are not intended to limit the scope of the disclosure. Therefore, the scope of the disclosure should be interpreted to include, in addition to the embodiments disclosed herein, all modifications or modified forms which are within the scope of protection defined by the appended claims.

## Claims

1. An electronic device (101, 200, 300, 401) comprising:
a wireless communication circuit (420);
an antenna (430);
a matching circuit (427) disposed between the wireless communication circuit (420) and the antenna (430);
at least one processor (410), comprising processing circuitry, operatively connected to the wireless communication circuit (420), the antenna (430), and the matching circuit (427); and
memory (130) storing instructions,
**characterised in that**
the matching circuit (427) comprises:
a first switching circuit (740) including a first switch connected to a first-first node and configured to switch a connection with ground, a second switch connected between the first-first node and a third node, a third switch connected to a first-second node and configured to switch a connection with ground, a fourth switch connected between the first-second node and the third node, a fifth switch connected to a first-third node and configured to switch a connection with ground, a sixth switch connected between the first-third node and the third node, a seventh switch connected to a first-fourth node and configured to switch a connection with ground, and an eighth switch connected between the first-fourth node and the third node;
a second switching circuit (760) including a ninth switch connected to a second-first node and configured to switch a connection with ground, a tenth switch connected between the second-first node and the third node, an eleventh switch connected to a second-second node and configured to switch a connection with ground, a twelfth switch connected between the second-second node and the third node, a thirteenth switch connected to a second-third node and configured to switch a connection with ground, a fourteenth switch connected between the second-third node and the third node, a fifteenth switch connected to a second-fourth node and configured to switch a connection with ground, and a sixteenth switch disposed between the second-fourth node and the third node;
a first inductor (781) connected between the first-second node and ground;
a second inductor (782) connected between the first-fourth node and ground;
a third inductor (783) connected between the second-fourth node and ground;
a first electrical path (750) electrically connecting the first switching circuit (740) and the second switching circuit (760);
a plurality of capacitors (710) disposed between the wireless communication circuit (420), the first switching circuit (740), and the second switching circuit (760);
a second electrical path (720) connecting the first electrical path (750) with one of the plurality of capacitors (710);
a third electrical path (785) connecting the second-second node and a feeding point of the antenna (430); and
a bypass line (714) connected to the second-first node, and
wherein the instructions, when executed individually or collectively by the at least one processor (410), cause the electronic device (101, 200, 300, 401) to:
based on a wireless signal being input, apply the wireless signal to at least one of the plurality of capacitors (710);
based on the wireless signal being applied to the at least one capacitor, control to turn on or off the plurality of switches of the first switching circuit (740) and the plurality of switches of the second switching circuit (760); and
based on the plurality of switches of the first switching circuit (740) and the plurality of switches of the second switching circuit (760) being controlled to be turned on or off, enable the matching circuit (427) to operate as a series variable capacitor and a shunt variable capacitor.

2. The electronic device (101, 200, 300, 401) of claim 1, wherein each of the first switching circuit (740) and the second switching circuit (760) includes a plurality of terminals.

3. The electronic device (101, 200, 300, 401) of claim 2, wherein the plurality of capacitors (710) comprise a first capacitor (711), a second capacitor (712), a third capacitor (713), and a fourth capacitor (715),
wherein the first capacitor (711) is connected to the first-first node through a first terminal among the plurality of terminals of the first switching circuit (740),
wherein the second capacitor (712) is connected to the first-third node through a second terminal among the plurality of terminals of the first switching circuit (740),
wherein the third capacitor (713) is connected to the third node through the second electrical path (720), and
wherein the fourth capacitor (715) is connected to the second-third node through a second terminal among the plurality of terminals of the second switching circuit (760).

4. The electronic device (101, 200, 300, 401) of claim 3, wherein the bypass line (714) is connected to the second-first node through a first terminal among the plurality of terminals of the second switching circuit (760).

5. The electronic device (101, 200, 300, 401) of claim 4, wherein the first terminal and the second terminal of the first switching circuit (740) and the first terminal and the second terminal of the second switching circuit (760) are input ports configured to receive a wireless signal.

6. The electronic device (101, 200, 300, 401) of claim 4, wherein the first inductor (781) is connected to the first-second node through a third terminal among the plurality of terminals of the first switching circuit (740),
wherein the second inductor (782) is connected to the first-fourth node through a fourth terminal among the plurality of terminals of the first switching circuit (740), and
wherein the third inductor (783) is connected to the second-fourth node through a fourth terminal among the plurality of terminals of the second switching circuit (760).

7. The electronic device (101, 200, 300, 401) of claim 6, wherein a third terminal of the plurality of terminals of the second switching circuit (760) is connected to a feeding point of the antenna (430) through a third electrical path (785).

8. The electronic device (101, 200, 300, 401) of claim 6, further comprising a second antenna,
wherein one of the first-second node, the first-fourth node, and the second-fourth node is connected to a feeding point of the second antenna and is not connected to the first inductor (781), the second inductor (782), and the third inductor (783).

9. The electronic device (101, 200, 300, 401) of claim 7, wherein the first switch, the third switch, the fifth switch, and the seventh switch of the first switching circuit (740) are connected in parallel to the first terminal and the second terminal of the first switching circuit (740),
wherein the second switch, the fourth switch, the sixth switch, and the eighth switch of the first switching circuit (740) are connected in series with the first terminal and the second terminal of the first switching circuit (740),
wherein the ninth switch, the eleventh switch, the thirteenth switch, and the fifteenth switch of the second switching circuit (760) are connected in parallel to the first terminal and the second terminal of the second switching circuit (760), and
wherein the tenth switch, the twelfth switch, the fourteenth switch, and the sixteenth switch of the second switching circuit (760) are connected in series with the first terminal and the second terminal of the second switching circuit (760).

10. The electronic device (101, 200, 300, 401) of claim 1, wherein the first switching circuit (740) and the second switching circuit (760) are configured as one package, or
wherein switches included in each of the first switching circuit (740) and the second switching circuit (760) are configured separately.

11. The electronic device (101, 200, 300, 401) of claim 3, wherein the instructions, when executed individually or collectively by the at least one processor (410), cause the electronic device (101, 200, 300, 401) to, based on operating in a bypass mode, deliver the wireless signal to the feeding point of the antenna (430) through the bypass line (714), to cause the antenna (430) to operate with a designated impedance.

12. The electronic device (101, 200, 300, 401) of claim 3, wherein the instructions, when executed individually or collectively by the at least one processor (410), cause the electronic device (101, 200, 300, 401) to:
based on the wireless signal being applied to at least one capacitor among the first capacitor (711), the second capacitor (712), or the fourth capacitor (715), control at least one switch configured to switch the connection between the at least one capacitor to which the wireless signal is applied and the ground to be turned on; and
based on the at least one switch configured to switch the connection between the at least one capacitor and the ground is controlled to be turned on, deliver the wireless signal to the feeding point of the antenna (430) to enable the matching circuit (427) to operate as the series variable capacitor.

13. The electronic device (101, 200, 300, 401) of claim 3, wherein the instructions, when executed individually or collectively by the at least one processor (410), cause the electronic device (101, 200, 300, 401) to:
based on the wireless signal being applied to at least one capacitor among the first capacitor (711), the second capacitor (712), or the fourth capacitor (715), control at least one switch configured to switch the connection between the at least one capacitor to which the wireless signal is applied and the ground to be turned off, control at least one switch connected in series with the at least one capacitor to which the wireless signal is applied to be turned on, and control at least one other switch configured to switch the connection between the at least one other capacitor and the ground to be turned on; and
based on the at least one switch configured to switch the connection between the at least one capacitor to which the wireless signal is applied and the ground being controlled to be turned off, the at least one switch connected in series with the at least one capacitor to which the wireless signal is applied is controlled to be turned on, and the at least one other switch configured to switch the connection between the at least one other capacitor and the ground is controlled to be turned on, deliver the wireless signal to the ground and the feeding point of the antenna (430) by the at least one other switch controlled to be turned on, to enable the matching circuit (427) to operate as the shunt variable capacitor.

14. The electronic device (101, 200, 300, 401) of claim 1, wherein the instructions, when executed individually or collectively by the at least one processor (410), cause the electronic device (101, 200, 300, 401) to, based on the matching circuit (427) operating as a series variable capacitor and a shunt variable capacitor, determine an impedance matching value of the wireless signal, based on a value of the series variable capacitor and a value of the shunt variable capacitor.

15. The electronic device (101, 200, 300, 401) of claim 3, wherein the one capacitor connected to the first electrical path (750) via the second electrical path (720) among the plurality of capacitors (710) has a fixed value,
wherein at least one remaining capacitor among the plurality of capacitors (710) has a variable value, and
wherein each of the plurality of capacitors (710) has a different time constant value.

## Patentansprüche

1. Elektronische Vorrichtung (101, 200, 300, 401), umfassend:
eine Drahtloskommunikationsschaltung (420);
eine Antenne (430);
eine Anpassungsschaltung (427), die zwischen der Drahtloskommunikationsschaltung (420) und der Antenne (430) angeordnet ist;
mindestens einen Prozessor (410), der eine Verarbeitungsschaltungsanordnung umfasst, die mit der Drahtloskommunikationsschaltung (420), der Antenne (430) und der Anpassungsschaltung (427) wirkverbunden ist; und
einen Speicher (130), der Anweisungen speichert,
**dadurch gekennzeichnet, dass** die Anpassungsschaltung (427) Folgendes umfasst:
einen ersten Schaltkreis (740), der einen ersten Schalter, der mit einem ersten ersten Knoten verbunden und dazu konfiguriert ist, eine Verbindung mit Masse zu schalten, einen zweiten Schalter, der zwischen dem ersten ersten Knoten und einem dritten Knoten verbunden ist, einen dritten Schalter, der mit einem ersten zweiten Knoten verbunden und dazu konfiguriert ist, eine Verbindung mit Masse zu schalten, einen vierten Schalter, der zwischen dem ersten zweiten Knoten und dem dritten Knoten verbunden ist, einen fünften Schalter, der mit einem ersten dritten Knoten verbunden und dazu konfiguriert ist, eine Verbindung mit Masse zu schalten, einen sechsten Schalter, der zwischen dem ersten dritten Knoten und dem dritten Knoten verbunden ist, einen siebten Schalter, der mit einem ersten vierten Knoten verbunden und dazu konfiguriert ist, eine Verbindung mit Masse zu schalten, und einen achten Schalter, der zwischen dem ersten vierten Knoten und dem dritten Knoten verbunden ist, enthält;
einen zweiten Schaltkreis (760), der einen neunten Schalter, der mit einem zweiten ersten Knoten verbunden und dazu konfiguriert ist, eine Verbindung mit Masse zu schalten, einen zehnten Schalter, der zwischen dem zweiten ersten Knoten und dem dritten Knoten verbunden ist, einen elften Schalter, der mit einem zweiten zweiten Knoten verbunden und dazu konfiguriert ist, eine Verbindung mit Masse zu schalten, einen zwölften Schalter, der zwischen dem zweiten zweiten Knoten und dem dritten Knoten verbunden ist, einen dreizehnten Schalter, der mit einem zweiten dritten Knoten verbunden und dazu konfiguriert ist, eine Verbindung mit Masse zu schalten, einen vierzehnten Schalter, der zwischen dem zweiten dritten Knoten und dem dritten Knoten verbunden ist, einen fünfzehnten Schalter, der mit einem zweiten vierten Knoten verbunden und dazu konfiguriert ist, eine Verbindung mit Masse zu schalten, und einen sechzehnten Schalter, der zwischen dem zweiten vierten Knoten und dem dritten Knoten angeordnet ist, enthält;
einen ersten Induktor (781), der zwischen dem ersten zweiten Knoten und Masse verbunden ist;
einen zweiten Induktor (782), der zwischen dem ersten vierten Knoten und Masse verbunden ist;
einen dritten Induktor (783), der zwischen dem zweiten vierten Knoten und Masse verbunden ist;
einen ersten elektrischen Pfad (750), der den ersten Schaltkreis (740) und den zweiten Schaltkreis (760) elektrisch verbindet;
eine Vielzahl von Kondensatoren (710), die zwischen der Drahtloskommunikationsschaltung (420), dem ersten Schaltkreis (740) und dem zweiten Schaltkreis (760) angeordnet sind;
einen zweiten elektrischen Pfad (720), der den ersten elektrischen Pfad (750) mit einem aus der Vielzahl von Kondensatoren (710) verbindet;
einen dritten elektrischen Pfad (785), der den zweiten zweiten Knoten und einen Speisepunkt der Antenne (430) verbindet; und
eine Bypassleitung (714), die mit dem zweiten ersten Knoten verbunden ist, und
wobei die Anweisungen, wenn sie einzeln oder gemeinsam durch den mindestens einen Prozessor (410) ausgeführt werden, die elektronische Vorrichtung (101, 200, 300, 401) zu Folgendem veranlassen:
basierend darauf, dass ein drahtloses Signal eingegeben wird, Anlegen des drahtlosen Signals an mindestens einen aus der Vielzahl von Kondensatoren (710);
basierend darauf, dass das drahtlose Signal an den mindestens einen Kondensator angelegt wird, Steuern, um die Vielzahl von Schaltern des ersten Schaltkreises (740) und die Vielzahl von Schaltern des zweiten Schaltkreises (760) ein- oder auszuschalten; und
basierend darauf, dass die Vielzahl von Schaltern des ersten Schaltkreises (740) und die Vielzahl von Schaltern des zweiten Schaltkreises (760) gesteuert werden, um ein- oder ausgeschaltet zu werden, Ermöglichen, dass die Anpassungsschaltung (427) als ein variabler Reihenkondensator und ein variabler Parallelkondensator arbeitet.

2. Elektronische Vorrichtung (101, 200, 300, 401) nach Anspruch 1, wobei jeder von dem ersten Schaltkreis (740) und dem zweiten Schaltkreis (760) eine Vielzahl von Anschlüssen enthält.

3. Elektronische Vorrichtung (101, 200, 300, 401) nach Anspruch 2, wobei die Vielzahl von Kondensatoren (710) einen ersten Kondensator (711), einen zweiten Kondensator (712), einen dritten Kondensator (713) und einen vierten Kondensator (715) umfasst,
wobei der erste Kondensator (711) durch einen ersten Anschluss aus der Vielzahl von Anschlüssen des ersten Schaltkreises (740) mit dem ersten ersten Knoten verbunden ist,
wobei der zweite Kondensator (712) mit dem ersten dritten Knoten durch einen zweiten Anschluss aus der Vielzahl von Anschlüssen des ersten Schaltkreises (740) verbunden ist,
wobei der dritte Kondensator (713) durch den zweiten elektrischen Pfad (720) mit dem dritten Knoten verbunden ist und
wobei der vierte Kondensator (715) mit dem zweiten dritten Knoten durch einen zweiten Anschluss aus der Vielzahl von Anschlüssen des zweiten Schaltkreises (760) verbunden ist.

4. Elektronische Vorrichtung (101, 200, 300, 401) nach Anspruch 3, wobei die Bypassleitung (714) mit dem zweiten ersten Knoten durch einen ersten Anschluss aus der Vielzahl von Anschlüssen des zweiten Schaltkreises (760) verbunden ist.

5. Elektronische Vorrichtung (101, 200, 300, 401) nach Anspruch 4, wobei der erste Anschluss und der zweite Anschluss des ersten Schaltkreises (740) und der erste Anschluss und der zweite Anschluss des zweiten Schaltkreises (760) Eingangsports sind, die dazu konfiguriert sind, ein drahtloses Signal zu empfangen.

6. Elektronische Vorrichtung (101, 200, 300, 401) nach Anspruch 4, wobei der erste Induktor (781) mit dem ersten zweiten Knoten durch einen dritten Anschluss aus der Vielzahl von Anschlüssen des ersten Schaltkreises (740) verbunden ist,
wobei der zweite Induktor (782) mit dem ersten vierten Knoten durch einen vierten Anschluss aus der Vielzahl von Anschlüssen des ersten Schaltkreises (740) verbunden ist und
wobei der dritte Induktor (783) mit dem zweiten vierten Knoten durch einen vierten Anschluss aus der Vielzahl von Anschlüssen des zweiten Schaltkreises (760) verbunden ist.

7. Elektronische Vorrichtung (101, 200, 300, 401) nach Anspruch 6, wobei ein dritter Anschluss der Vielzahl von Anschlüssen des zweiten Schaltkreises (760) mit einem Speisepunkt der Antenne (430) durch einen dritten elektrischen Pfad (785) verbunden ist.

8. Elektronische Vorrichtung (101, 200, 300, 401) nach Anspruch 6, ferner umfassend eine zweite Antenne,
wobei einer von dem ersten zweiten Knoten, dem ersten vierten Knoten und dem zweiten vierten Knoten mit einem Speisepunkt der zweiten Antenne verbunden ist und nicht mit dem ersten Induktor (781), dem zweiten Induktor (782) und dem dritten Induktor (783) verbunden ist.

9. Elektronische Vorrichtung (101, 200, 300, 401) nach Anspruch 7, wobei der erste Schalter, der dritte Schalter, der fünfte Schalter und der siebte Schalter des ersten Schaltkreises (740) parallel mit dem ersten Anschluss und dem zweiten Anschluss des ersten Schaltkreises (740) verbunden sind,
wobei der zweite Schalter, der vierte Schalter, der sechste Schalter und der achte Schalter des ersten Schaltkreises (740) in Reihe mit dem ersten Anschluss und dem zweiten Anschluss des ersten Schaltkreises (740) verbunden sind,
wobei der neunte Schalter, der elfte Schalter, der dreizehnte Schalter und der fünfzehnte Schalter des zweiten Schaltkreises (760) parallel mit dem ersten Anschluss und dem zweiten Anschluss des zweiten Schaltkreises (760) verbunden sind und
wobei der zehnte Schalter, der zwölfte Schalter, der vierzehnte Schalter und der sechzehnte Schalter des zweiten Schaltkreises (760) in Reihe mit dem ersten Anschluss und dem zweiten Anschluss des zweiten Schaltkreises (760) verbunden sind.

10. Elektronische Vorrichtung (101, 200, 300, 401) nach Anspruch 1, wobei der erste Schaltkreis (740) und der zweite Schaltkreis (760) als eine Baugruppe konfiguriert sind oder
wobei Schalter, die in jedem von dem ersten Schaltkreis (740) und dem zweiten Schaltkreis (760) enthalten sind, separat konfiguriert sind.

11. Elektronische Vorrichtung (101, 200, 300, 401) nach Anspruch 3, wobei die Anweisungen, wenn sie einzeln oder gemeinsam durch den mindestens einen Prozessor (410) ausgeführt werden, die elektronische Vorrichtung (101, 200, 300, 401) veranlassen, basierend darauf, dass sie in einem Bypassmodus arbeitet, das drahtlose Signal durch die Bypassleitung (714) an den Speisepunkt der Antenne (430) zu liefern, um die Antenne (430) zu veranlassen, mit einer festgelegten Impedanz zu arbeiten.

12. Elektronische Vorrichtung (101, 200, 300, 401) nach Anspruch 3, wobei die Anweisungen, wenn sie einzeln oder gemeinsam durch den mindestens einen Prozessor (410) ausgeführt werden, die elektronische Vorrichtung (101, 200, 300, 401) zu Folgendem veranlassen:
basierend darauf, dass das drahtlose Signal an mindestens einen Kondensator aus dem ersten Kondensator (711), dem zweiten Kondensator (712) oder dem vierten Kondensator (715) angelegt wird, Steuern mindestens eines Schalters, der dazu konfiguriert ist, die Verbindung zwischen dem mindestens einen Kondensator, an den das drahtlose Signal angelegt wird, und der Masse zu schalten, sodass er eingeschaltet wird; und
basierend darauf, dass der mindestens eine Schalter, der dazu konfiguriert ist, die Verbindung zwischen dem mindestens einen Kondensator und der Masse zu schalten, gesteuert wird, sodass er eingeschaltet wird, Liefern des drahtlosen Signals an den Speisepunkt der Antenne (430), um zu ermöglichen, dass die Anpassungsschaltung (427) als der variable Reihenkondensator arbeitet.

13. Elektronische Vorrichtung (101, 200, 300, 401) nach Anspruch 3, wobei die Anweisungen, wenn sie einzeln oder gemeinsam durch den mindestens einen Prozessor (410) ausgeführt werden, die elektronische Vorrichtung (101, 200, 300, 401) zu Folgendem veranlassen:
basierend darauf, dass das drahtlose Signal an mindestens einen Kondensator aus dem ersten Kondensator (711), dem zweiten Kondensator (712) oder dem vierten Kondensator (715) angelegt wird, Steuern mindestens eines Schalters, der dazu konfiguriert ist, die Verbindung zwischen dem mindestens einen Kondensator, an den das drahtlose Signal angelegt wird, und der Masse zu schalten, sodass er abgeschaltet wird, Steuern mindestens eines Schalters, der in Reihe mit dem mindestens einen Kondensator verbunden ist, an den das drahtlose Signal angelegt wird, sodass er eingeschaltet wird, und Steuern mindestens eines anderen Schalters, der dazu konfiguriert ist, die Verbindung zwischen dem mindestens einen anderen Kondensator und der Masse zu schalten, sodass er eingeschaltet wird; und
basierend darauf, dass der mindestens eine Schalter, der dazu konfiguriert ist, die Verbindung zwischen dem mindestens einen Kondensator, an den das drahtlose Signal angelegt wird, und der Masse zu schalten, gesteuert wird, sodass er abgeschaltet wird, der mindestens eine Schalter, der in Reihe mit dem mindestens einen Kondensator, an den das drahtlose Signal angelegt wird, geschaltet wird, gesteuert wird, sodass er eingeschaltet wird, und der mindestens eine andere Schalter, der dazu konfiguriert ist, die Verbindung zwischen dem mindestens einen anderen Kondensator und der Masse zu schalten, gesteuert wird, sodass er eingeschaltet wird, Liefern des drahtlosen Signals durch den mindestens einen anderen Schalter, der gesteuert wird, sodass er eingeschaltet wird, an die Masse und den Speisepunkt der Antenne (430), um es der Anpassungsschaltung (427) zu ermöglichen, als der variable Parallelkondensator zu arbeiten.

14. Elektronische Vorrichtung (101, 200, 300, 401) nach Anspruch 1, wobei die Anweisungen, wenn sie einzeln oder gemeinsam durch den mindestens einen Prozessor (410) ausgeführt werden, die elektronische Vorrichtung (101, 200, 300, 401) veranlassen, basierend darauf, dass die Anpassungsschaltung (427) als ein variabler Reihenkondensator und ein variabler Parallelkondensator arbeitet, einen Impedanzanpassungswert des drahtlosen Signals basierend auf einem Wert des variablen Reihenkondensators und einem Wert des variablen Parallelkondensators zu bestimmen.

15. Elektronische Vorrichtung (101, 200, 300, 401) nach Anspruch 3, wobei der eine Kondensator, der mit dem ersten elektrischen Pfad (750) über den zweiten elektrischen Pfad (720) verbunden ist, aus der Vielzahl von Kondensatoren (710) einen festen Wert aufweist,
wobei mindestens ein verbleibender Kondensator aus der Vielzahl von Kondensatoren (710) einen variablen Wert aufweist und
wobei jeder aus der Vielzahl von Kondensatoren (710) einen unterschiedlichen Zeitkonstantenwert aufweist.

## Revendications

1. Dispositif électronique (101, 200, 300, 401) comprenant :
un circuit de communication sans fil (420) ;
une antenne (430) ;
un circuit d'adaptation (427) disposé entre le circuit de communication sans fil (420) et l'antenne (430) ;
au moins un processeur (410), comprenant des circuits de traitement, fonctionnellement connectés au circuit de communication sans fil (420), à l'antenne (430) et au circuit d'adaptation (427) ; et
une mémoire (130) stockant des instructions,
**caractérisé en ce que** le circuit d'adaptation (427) comprend :
un premier circuit de commutation (740) comprenant un premier commutateur connecté à un premier premier nœud et configuré pour commuter une connexion avec la terre, un deuxième commutateur connecté entre le premier premier nœud et un troisième nœud, un troisième commutateur connecté à un premier deuxième nœud et configuré pour commuter une connexion avec la terre, un quatrième commutateur connecté entre le premier deuxième nœud et le troisième nœud, un cinquième commutateur connecté à un premier troisième nœud et configuré pour commuter une connexion avec la terre, un sixième commutateur connecté entre le premier troisième nœud et le troisième nœud, un septième commutateur connecté à un premier quatrième nœud et configuré pour commuter une connexion avec la terre, et un huitième commutateur connecté entre le premier quatrième nœud et le troisième nœud ;
un second circuit de commutation (760) comprenant un neuvième commutateur connecté à un deuxième premier nœud et configuré pour commuter une connexion avec la terre, un dixième commutateur connecté entre le deuxième premier nœud et le troisième nœud, un onzième commutateur connecté à un deuxième deuxième nœud et configuré pour commuter une connexion avec la terre, un douzième commutateur connecté entre le deuxième deuxième nœud et le troisième nœud, un treizième commutateur connecté à un deuxième troisième nœud et configuré pour commuter une connexion avec la terre, un quatorzième commutateur connecté entre le deuxième troisième nœud et le troisième nœud, un quinzième commutateur connecté à un deuxième quatrième nœud et configuré pour commuter une connexion avec la terre, et un seizième commutateur disposé entre le deuxième quatrième nœud et le troisième nœud ;
un premier inducteur (781) connecté entre le premier deuxième nœud et la terre ;
un deuxième inducteur (782) connecté entre le premier quatrième nœud et la terre ;
un troisième inducteur (783) connecté entre le deuxième quatrième nœud et la terre ;
un premier chemin électrique (750) connectant électriquement le premier circuit de commutation (740) et le second circuit de commutation (760) ;
une pluralité de condensateurs (710) disposés entre le circuit de communication sans fil (420), le premier circuit de commutation (740) et le second circuit de commutation (760) ;
un deuxième chemin électrique (720) connectant le premier chemin électrique (750) à l'un de la pluralité de condensateurs (710) ;
un troisième chemin électrique (785) connectant le deuxième deuxième nœud et un point d'alimentation de l'antenne (430) ; et
une ligne de dérivation (714) connectée au deuxième premier nœud, et
dans lequel les instructions, lorsqu'elles sont exécutées individuellement ou collectivement par l'au moins un processeur (410), amènent le dispositif électronique (101, 200, 300, 401) à :
sur la base de l'entrée d'un signal sans fil, appliquer le signal sans fil à au moins l'un de la pluralité de condensateurs (710) ;
sur la base de l'application du signal sans fil à l'au moins un condensateur, commander la mise en conduction ou hors conduction de la pluralité de commutateurs du premier circuit de commutation (740) et la pluralité de commutateurs du second circuit de commutation (760) ; et
sur la base de la commande de mise en conduction ou hors conduction de la pluralité de commutateurs du premier circuit de commutation (740) et de la pluralité de commutateurs du second circuit de commutation (760), permettre au circuit d'adaptation (427) de fonctionner comme un condensateur variable en série et un condensateur variable en dérivation.

2. Dispositif électronique (101, 200, 300, 401) de la revendication 1, dans lequel chacun du premier circuit de commutation (740) et du second circuit de commutation (760) comprend une pluralité de bornes.

3. Dispositif électronique (101, 200, 300, 401) de la revendication 2, dans lequel la pluralité de condensateurs (710) comprennent un premier condensateur (711), un deuxième condensateur (712), un troisième condensateur (713) et un quatrième condensateur (715),
dans lequel le premier condensateur (711) est connecté au premier premier nœud via une première borne parmi la pluralité de bornes du premier circuit de commutation (740),
dans lequel le deuxième condensateur (712) est connecté au premier troisième nœud via une deuxième borne parmi la pluralité de bornes du premier circuit de commutation (740),
dans lequel le troisième condensateur (713) est connecté au troisième nœud via le deuxième chemin électrique (720), et
dans lequel le quatrième condensateur (715) est connecté au deuxième troisième nœud via une deuxième borne parmi la pluralité de bornes du second circuit de commutation (760).

4. Dispositif électronique (101, 200, 300, 401) de la revendication 3, dans lequel la ligne de dérivation (714) est connectée au deuxième premier nœud via une première borne parmi la pluralité de bornes du second circuit de commutation (760).

5. Dispositif électronique (101, 200, 300, 401) de la revendication 4, dans lequel la première borne et la deuxième borne du premier circuit de commutation (740) et la première borne et la deuxième borne du second circuit de commutation (760) sont des ports d'entrée configurés pour recevoir un signal sans fil.

6. Dispositif électronique (101, 200, 300, 401) de la revendication 4, dans lequel le premier inducteur (781) est connecté au premier deuxième nœud via une troisième borne parmi la pluralité de bornes du premier circuit de commutation (740),
dans lequel le deuxième inducteur (782) est connecté au premier quatrième nœud via une quatrième borne parmi la pluralité de bornes du premier circuit de commutation (740), et
dans lequel le troisième inducteur (783) est connecté au deuxième quatrième nœud via une quatrième borne parmi la pluralité de bornes du second circuit de commutation (760).

7. Dispositif électronique (101, 200, 300, 401) de la revendication 6, dans lequel une troisième borne de la pluralité de bornes du second circuit de commutation (760) est connectée à un point d'alimentation de l'antenne (430) via un troisième chemin électrique (785).

8. Dispositif électronique (101, 200, 300, 401) de la revendication 6, comprenant en outre une seconde antenne,
dans lequel l'un du premier deuxième nœud, du premier quatrième nœud et du deuxième quatrième nœud est connecté à un point d'alimentation de la seconde antenne et n'est pas connecté au premier inducteur (781), au deuxième inducteur (782) et au troisième inducteur (783).

9. Dispositif électronique (101, 200, 300, 401) de la revendication 7, dans lequel le premier commutateur, le troisième commutateur, le cinquième commutateur et le septième commutateur du premier circuit de commutation (740) sont connectés en parallèle à la première borne et à la deuxième borne du premier circuit de commutation (740),
dans lequel le deuxième commutateur, le quatrième commutateur, le sixième commutateur et le huitième commutateur du premier circuit de commutation (740) sont connectés en série avec la première borne et la deuxième borne du premier circuit de commutation (740),
dans lequel le neuvième commutateur, le onzième commutateur, le treizième commutateur et le quinzième commutateur du second circuit de commutation (760) sont connectés en parallèle à la première borne et à la deuxième borne du second circuit de commutation (760), et
dans lequel le dixième commutateur, le douzième commutateur, le quatorzième commutateur et le seizième commutateur du second circuit de commutation (760) sont connectés en série avec la première borne et la deuxième borne du second circuit de commutation (760).

10. Dispositif électronique (101, 200, 300, 401) de la revendication 1, dans lequel le premier circuit de commutation (740) et le second circuit de commutation (760) sont configurés comme un seul boîtier, ou
dans lequel les commutateurs compris dans chacun du premier circuit de commutation (740) et du second circuit de commutation (760) sont configurés séparément.

11. Dispositif électronique (101, 200, 300, 401) de la revendication 3, dans lequel les instructions, lorsqu'elles sont exécutées individuellement ou collectivement par l'au moins un processeur (410), amènent le dispositif électronique (101, 200, 300, 401) à, sur la base d'un fonctionnement en mode de dérivation, délivrer le signal sans fil au point d'alimentation de l'antenne (430) via la ligne de dérivation (714), pour amener l'antenne (430) à fonctionner avec une impédance désignée.

12. Dispositif électronique (101, 200, 300, 401) de la revendication 3, dans lequel les instructions, lorsqu'elles sont exécutées individuellement ou collectivement par l'au moins un processeur (410), amènent le dispositif électronique (101, 200, 300, 401) à :
sur la base de l'application du signal sans fil à au moins un condensateur parmi le premier condensateur (711), le deuxième condensateur (712) ou le quatrième condensateur (715), commander la mise en conduction d'au moins un commutateur configuré pour commuter la connexion entre l'au moins un condensateur auquel le signal sans fil est appliqué et la terre ; et
sur la base de la commande de mise en conduction de l'au moins un commutateur configuré pour commuter la connexion entre l'au moins un condensateur et la terre, délivrer le signal sans fil au point d'alimentation de l'antenne (430) pour permettre au circuit d'adaptation (427) de fonctionner comme le condensateur variable en série.

13. Dispositif électronique (101, 200, 300, 401) de la revendication 3, dans lequel les instructions, lorsqu'elles sont exécutées individuellement ou collectivement par l'au moins un processeur (410), amènent le dispositif électronique (101, 200, 300, 401) à :
sur la base de l'application du signal sans fil à au moins un condensateur parmi le premier condensateur (711), le deuxième condensateur (712) ou le quatrième condensateur (715), commander la mise hors conduction d'au moins un commutateur configuré pour commuter la connexion entre l'au moins un condensateur auquel le signal sans fil est appliqué et la terre, commander la mise en conduction d'au moins un commutateur connecté en série avec l'au moins un condensateur auquel le signal sans fil est appliqué, et commander la mise en conduction d'au moins un autre commutateur configuré pour commuter la connexion entre l'au moins un autre condensateur et la terre ; et
sur la base de la commande de mise hors conduction de l'au moins un commutateur configuré pour commuter la connexion entre l'au moins un condensateur auquel le signal sans fil est appliqué et la terre, la mise en conduction de l'au moins un commutateur connecté en série avec l'au moins un condensateur auquel le signal sans fil est appliqué est commandée, et la mise en conduction de l'au moins un autre commutateur configuré pour commuter la connexion entre l'au moins un autre condensateur et la terre est commandée, délivrer le signal sans fil à la terre et au point d'alimentation de l'antenne (430) par l'au moins un autre commutateur dont la mise en conduction est commandée, afin de permettre au circuit d'adaptation (427) de fonctionner comme le condensateur variable en dérivation.

14. Dispositif électronique (101, 200, 300, 401) de la revendication 1, dans lequel les instructions, lorsqu'elles sont exécutées individuellement ou collectivement par l'au moins un processeur (410), amènent le dispositif électronique (101, 200, 300, 401) à, sur la base du circuit d'adaptation (427) fonctionnant comme un condensateur variable en série et un condensateur variable en dérivation, déterminer une valeur d'adaptation d'impédance du signal sans fil, sur la base d'une valeur du condensateur variable en série et d'une valeur du condensateur variable en dérivation.

15. Dispositif électronique (101, 200, 300, 401) de la revendication 3, dans lequel le condensateur connecté au premier chemin électrique (750) via le deuxième chemin électrique (720) parmi la pluralité de condensateurs (710) a une valeur fixe,
dans lequel au moins un condensateur restant parmi la pluralité de condensateurs (710) présente une valeur variable, et
dans lequel chacun de la pluralité de condensateurs (710) présente une valeur de constante de temps différente.
